(19) **Europäisches Patentamt / European Patent Office / Office européen des brevets**

(11) **EP 4 437 582 B1**

(12) **FASCICULE DE BREVET EUROPEEN**

(45) Date de publication et mention de la délivrance du brevet:
**31.12.2025 Bulletin 2026/01**

(21) Numéro de dépôt: **22817756.4**

(22) Date de dépôt: **16.11.2022**

(51) Classification Internationale des Brevets (IPC):
*H01L 21/67* *(2006.01)*    *H01L 21/00* *(2006.01)*
*H01L 21/66* *(2006.01)*

(52) Classification Coopérative des Brevets (CPC):
**H01L 21/67;** H01L 22/12

(86) Numéro de dépôt international:
**PCT/EP2022/082167**

(87) Numéro de publication internationale:
**WO 2023/094244 (01.06.2023 Gazette 2023/22)**

(54) **SYSTÈME POUR DÉFORMER UNE STRUCTURE UTILE**

SYSTEM ZUM VERFORMEN EINER EFFEKTIVEN STRUKTUR

SYSTEM FOR DEFORMING AN EFFECTIVE STRUCTURE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats de validation désignés:
**MA**

(30) Priorité: **26.11.2021 FR 2112600**

(43) Date de publication de la demande:
**02.10.2024 Bulletin 2024/40**

(73) Titulaires:
• **Nelumbo Digital**
  **38920 Crolles (FR)**
• **European Synchrotron Radiation Facility**
  **38000 Grenoble (FR)**

(72) Inventeurs:
• **LE VAILLANT, Yves-Matthieu**
  **38920 CROLLES (FR)**
• **SCHÜLLI, Tobias**
  **38000 Grenoble (FR)**

(74) Mandataire: **INNOV-GROUP**
  **209 Avenue Berthelot**
  **69007 Lyon (FR)**

(56) Documents cités:
**EP-A1- 1 520 669    FR-A1- 2 789 518
US-B1- 9 559 075**

## Description

### Domaine technique

L'invention se rapporte au domaine technique de l'ingénierie et de la science des déformations imposées à un matériau.

L'invention trouve notamment son application dans :

- la caractérisation *operando* de la déformation du matériau ;
- la fabrication d'un substrat avancé ou d'un composant comportant le matériau déformé ;
- la fabrication d'un composant accordable comportant le matériau déformé, permettant d'accorder la déformation du matériau durant le fonctionnement du composant.

### État de l'art

La déformation d'un matériau peut fortement affecter ses propriétés physiques.

Notamment, les matériaux de type semiconducteur subissent sous déformation une modification notable de leur structure de bandes électroniques pouvant entraîner :

- une modification de la mobilité des porteurs ;
- une modification régulière de l'énergie de la bande interdite pouvant même entraîner une transition de son type indirect vers direct ;
- une modification régulière de la barrière énergétique des hétérostructures (voire des puits quantiques).

Ces changements de leurs propriétés électroniques peuvent procurer des avantages potentiels significatifs.

La déformation des matériaux de type pérovskite peut modifier de manière encore plus spectaculaire les propriétés physiques, notamment avec des changements de phase entraînant par exemple l'apparition de la ferroélectricité ou du ferromagnétisme.

Un système pour déformer une structure utile, connu de l'état de la technique, comporte un appareil à enclumes de diamant. L'appareil comporte :

- la structure utile à déformer ;
- deux enclumes, réalisées dans un matériau dur (typiquement en diamant, saphir ou rubis), et s'étendant de part et d'autre de la structure utile ;
- des moyens de compression, agencés pour appliquer aux enclumes une force de compression selon un axe de compression.

Un tel système de l'état de la technique n'est pas entièrement satisfaisant dans la mesure où :

(i) l'obtention d'une déformation en tension de la structure utile, selon un axe perpendiculaire à l'axe de compression, nécessite d'exercer une pression considérable sur les enclumes (de l'ordre de plusieurs centaines d'atmosphères) ;

(ii) la déformation en tension obtenue demeure très limitée (par exemple de l'ordre de 0,05%), malgré la pression importante exercée sur les enclumes ;

(iii) la structure utile doit présenter une forte résistance mécanique, capable de supporter la pression élevée.

Le document suivant a été mentionné comme étant une illustration pertinente de l'état de l'art:

FR 2 789 518 A1 divulgue un procédé, et appareil associé, de réalisation d'une structure multicouches à contraintes internes.

Les documents suivants sont aussi mentionnés comme étant une illustration complémentaire de l'état de l'art:

US 9 559 075 A1
EP 1 520 669 A1

### Exposé de l'invention

L'invention vise à remédier en tout ou partie aux inconvénients précités. A cet effet, l'invention a pour objet un système pour déformer une structure utile, comportant :

- un empilement comprenant successivement la structure utile et une matrice tampon ; l'empilement possédant une interface entre la structure utile et la matrice tampon, l'interface présentant un plan moyen ;
- des moyens de compression, agencés pour appliquer à l'empilement une force de compression selon la normale au plan moyen de l'interface ;
- des moyens de cisaillement, agencés pour appliquer à la matrice tampon des forces de cisaillement longitudinales, parallèles au plan moyen de l'interface ;

la matrice tampon étant adaptée pour transmettre les forces de cisaillement à la structure utile, dans le plan moyen de l'interface, de manière à déformer la structure utile.

***Définitions***

- Par « déformer », on entend le fait de modifier l'état de contrainte. Par « état de contrainte », on entend les contraintes résultant des efforts internes mis en jeu entre des parties déformées de la structure utile, les efforts internes pouvant être en tension ou en compression. Lorsque les efforts internes sont nuls ou quasi nuls, on parle d'état relaxé pour désigner l'état de contrainte correspondant.
- Par « structure utile », on entend une structure comportant un matériau à déformer. La structure utile peut être un composant. La structure utile peut être une structure à partir de laquelle sera fabriqué un composant. Le composant peut être destiné à des applications notamment dans les domaines de la microélectronique, l'optique, l'optoélectronique, la piézoélectricité, la ferroélectricité, l'anti-ferroélectricité, la pyroélectricité ou encore la spintronique.
- Par « empilement », on entend une succession d'éléments suivant une direction verticale.
- Par « successivement », on entend du niveau le plus bas de l'empilement vers le niveau le plus haut de l'empilement.
- Par « matrice tampon », on entend un matériau recouvrant la structure utile de manière à lisser les variations locales de contraintes s'exerçant sur la structure utile lors de la compression de l'empilement.
- Par « plan moyen », on entend un plan de référence à 3 points de la surface de contact (définissant l'interface entre la structure utile et la matrice tampon), tel que défini dans la norme ASTM F534, §3.1.2. pour la mesure d'une courbure d'arc (« *bow* » en langue anglaise), ou dans la norme ASTM F1390 pour la mesure d'un voilage (« *warp* » en langue anglaise).

Ainsi, contrairement à l'état de la technique, un tel système selon l'invention permet de déformer une structure utile comportant un matériau fragile à déformer, grâce à la présence d'une telle matrice tampon. En effet, la matrice tampon permet d'améliorer l'homogénéité de la sollicitation de la structure utile, limitant par là-même les risques de rupture du matériau à déformer.

En outre, les moyens de cisaillement autorisent, selon un axe perpendiculaire à l'axe de compression, une déformation de la structure utile à un taux beaucoup plus important que dans l'état de la technique.

Par ailleurs, l'action conjointe des moyens de cisaillement et des moyens de compression permettent d'augmenter la ténacité de l'interface entre la structure utile et la matrice tampon en diminuant les risques de délamination, et en améliorant l'efficacité de transmission des forces de cisaillement à la structure utile.

Le système selon l'invention peut comporter une ou plusieurs des caractéristiques suivantes.

Selon une caractéristique de l'invention, les moyens de cisaillement comportent un organe de préhension de la matrice tampon, mobile en translation selon une direction longitudinale, parallèle au plan moyen de l'interface.

Ainsi, un avantage procuré est d'obtenir des moyens de cisaillement externes à l'empilement pouvant aisément être mis en œuvre dans un contexte industriel.

Selon une caractéristique de l'invention, les moyens de cisaillement comportent un parallélogramme articulé, agencé pour mouvoir l'organe de préhension en translation selon la direction longitudinale.

Ainsi, un avantage procuré par un mécanisme à quatre barres (articulées entre elles par des liaisons pivot) est sa simplicité pour obtenir un mouvement de translation.

Selon une caractéristique de l'invention, l'organe de préhension est mobile en rotation autour d'un axe de rotation perpendiculaire au plan moyen de l'interface.

Ainsi, un avantage procuré est de pouvoir contrôler l'axe longitudinal des forces de cisaillement s'appliquant à la matrice tampon, dans un plan parallèle au plan moyen de l'interface entre la structure utile et la matrice tampon.

Selon une caractéristique de l'invention, l'empilement comprend une couche caoutchoutique ; la matrice tampon étant intercalée entre la structure utile et la couche caoutchoutique ; et les moyens de cisaillement comportent la couche caoutchoutique, la couche caoutchoutique étant adaptée pour convertir la force de compression en des forces de cisaillement longitudinales, parallèles au plan moyen de l'interface, s'appliquant à la matrice tampon.

***Définitions***

- Par « couche », on entend une couche ou une pluralité de sous-couches de même nature.
- Par « caoutchoutique », on entend que la couche est réalisée dans un matériau à base d'un caoutchouc, naturel ou synthétique. Par « à base de », on entend que le caoutchouc est le matériau principal et majoritaire composant la couche.

Ainsi, un avantage procuré par la couche caoutchoutique est d'obtenir des moyens de cisaillement internes à l'empilement. La couche caoutchoutique possède une grande efficacité pour convertir la force de compression (normale au plan moyen de l'interface) en des forces de cisaillement longitudinales (parallèles au plan moyen de l'interface). En effet, une couche caoutchoutique possède des propriétés intéressantes d'élasticité et d'incompressibilité avec un module d'Young compris entre 1 MPa et 100 MPa et un coefficient de Poisson proche de 0,5. En outre, la couche caoutchoutique permet une grande homogénéité de la sollicitation de la matrice tampon, conduisant par là-même à une bonne homogénéité de la déformation de la structure utile.

Il est possible de démontrer (cf. formule ci-après) que la pression exercée sur l'empilement par les moyens de compression et l'épaisseur de la couche caoutchoutique sont les deux paramètres principaux permettant d'ajuster une déformation cible pour la structure utile :

$$\sigma_V(\varepsilon_L) = \varepsilon_L \left( \frac{32ES^2 s_L}{\frac{64}{3}ES^2 h + 3s_L} + \frac{4}{3}(1 + 2S^2)E\left(1 + \frac{3s_L}{16ES^2 h}\right) + \frac{s_L^2}{\frac{32}{9}ES^2 h + \frac{2}{3}s_L h}\right),$$

où :

- $\sigma_V$ est la pression liée à la force de compression exercée sur l'empilement selon la normale à l'interface,
- $\varepsilon_L$ est la déformation biaxiale isotrope de l'ensemble structure utile/matrice tampon,
- E est le module d'Young de la couche caoutchoutique,
- h est la hauteur de la couche caoutchoutique considérée de forme cylindrique,
- $S = \frac{\pi r^2}{2\pi r h} = \frac{r}{2h}$ , où r est le rayon de la couche caoutchoutique considérée de forme cylindrique,
- $s_L = E'_L\, t_L$ , où E'$_L$ est le module élastique biaxial de l'ensemble structure utile/matrice tampon, et t$_L$ est l'épaisseur de l'ensemble structure utile/matrice tampon.

Le choix d'une faible épaisseur pour la couche caoutchoutique doit être compensée par une pression élevée à exercer sur l'empilement. Le choix d'une forte épaisseur pour la couche caoutchoutique permet de réduire la pression requise pour une déformation latérale donnée. A contrario, une pression plus élevée favorise la friction, potentiellement utile pour éviter le glissement entre la matrice tampon et la structure utile, ou entre la matrice tampon et la couche caoutchoutique.

De tels moyens de cisaillement internes à l'empilement peuvent coexister avec des moyens de cisaillement externes à l'empilement, ce qui permet d'envisager des déformations biaxiales (éventuellement anisotropes) de la structure utile dans le plan moyen de l'interface entre la structure utile et la matrice tampon.

Selon une caractéristique de l'invention, la couche caoutchoutique est réalisée dans un matériau choisi parmi :

- un polymère de type silicone, comprenant de préférence le polydiméthylsiloxane ;
- l'éthylène-acétate de vinyle ;
- un polyuréthane ;
- un polyacrylique ;
- le butadiène ;
- un composé comprenant un groupement butyle ;
- un caoutchouc de type EPDM ;
- un fluoroélastomère, notamment un perfluoroélastomère ;
- l'isoprène ;
- un composé comprenant un groupement nitrile ;
- le polychloroprène ;
- le styrène-butadiène.

*Définition*

« EPDM » est le sigle désignant éthylène-propylène-diène monomère.

Un avantage particulier du polydiméthylsiloxane (PDMS) est sa transparence optique élevée dans la bande visible et le proche infrarouge, ce qui est une propriété intéressante en vue d'une caractérisation optique de la déformation de la structure utile.

Selon une caractéristique de l'invention, la matrice tampon possède un module d'Young supérieur ou égal à 1 GPa.

Ainsi, un avantage procuré est d'obtenir une matrice tampon résiliente vis-à-vis de la force de compression s'exerçant sur l'empilement. Le matériau de la matrice tampon est avantageusement choisi pour présenter un module d'Young adapté au module d'Young de la structure utile de sorte que le gradient de modules d'Young est le plus faible possible, et ce afin de réduire les risques de fissuration de la structure utile liés à des hétérogénéités locales de déformation. La quantité correspondant à l'épaisseur multipliée par le module d'Young est préférablement choisie du même ordre de grandeur pour la matrice tampon et pour la structure utile.

Selon une caractéristique de l'invention, la structure utile possède un taux de déformation à la rupture, noté $\tau_{R1}$, et la matrice tampon possède un taux de déformation à la rupture, noté $\tau_{R2}$, vérifiant $\tau_{R2} > \tau_{R1}$.

Ainsi, un avantage procuré est de protéger la structure utile d'un clivage ou d'une rupture lors de la compression de l'empilement.

Selon une caractéristique de l'invention, la matrice tampon est réalisée dans un matériau choisi parmi :

- un polymère, de préférence un polyimide, le polycarbonate, un polyéthérimide, un polyamide-imide, le polyéthylène, un verre, le polyétheréthercétone, le polypropylène, le polyméthacrylate de méthyle, le polyéthersulfone, le polychlorure de vinyle, le polystyrène, le polytéréphtalate d'éthylène ;
- une céramique, de préférence SiN, SiC, $Al_2O_3$.

Selon une caractéristique de l'invention, la structure utile est choisie parmi une :

- une structure à base d'un matériau de type semiconducteur ;
- une structure à base d'un matériau de type pérovskite ;
- une structure de type cristal photonique ;
- une structure à base d'un matériau composite ;
- un cristal ;
- un métal ;
- un polymère ;
- une céramique ;
- une chaux ;
- un ciment.

*Définition*

Par « à base de », on entend que le matériau correspondant est le matériau principal et majoritaire composant la structure.

Selon une caractéristique de l'invention, les moyens de compression comportent une plaque inférieure et une plaque supérieure, agencées pour enserrer l'empilement.

*Définition*

Les termes « inférieure » et « supérieure » désignent la position relative des plaques correspondantes par rapport à l'empilement (s'étendant suivant une direction verticale). La plaque inférieure est située sous l'empilement tandis que la plaque supérieure est située sur l'empilement.

Selon une caractéristique de l'invention, la plaque supérieure présente une surface de contact non-plane avec la couche caoutchoutique, la surface de contact non-plane étant géométriquement adaptée de sorte que la couche caoutchoutique convertit la force de compression en des forces de cisaillement longitudinales, parallèles au plan moyen de l'interface, s'appliquant de manière anisotrope à la matrice tampon.

Ainsi, un avantage procuré est d'autoriser des déformations biaxiales anisotropes de la structure utile, dans le plan moyen de l'interface entre la structure utile et la matrice tampon, et ce sans nécessiter la présence de moyens de cisaillement externes à l'empilement.

Selon une caractéristique de l'invention, l'empilement comprend une couche anti-glissement, intercalée entre la structure utile et la matrice tampon, la couche anti-glissement possédant un coefficient de friction adapté pour maintenir en position la structure utile au sein de l'empilement.

Ainsi, un avantage procuré est d'éviter un glissement de la matrice tampon sur la structure utile et une mise en contact direct de la matrice tampon sur la structure utile.

Selon une caractéristique de l'invention, l'empilement comprend un film de collage, intercalé entre la structure utile et la matrice tampon.

Ainsi, un avantage procuré est d'éviter un glissement de la matrice tampon sur la structure utile et une mise en contact direct de la matrice tampon sur la structure utile.

L'invention a également pour objet un ensemble de caractérisation d'une structure utile à déformer, comportant :

- un système conforme à l'invention ;
- un instrument de caractérisation, agencé pour mesurer la déformation de la structure utile, l'instrument de caractérisation étant de préférence choisi parmi :

  un spectroscope, de préférence un diffractomètre à rayons X, un spectromètre Raman, un spectroscope de photoluminescence, un spectroscope de réflectance ;
  un instrument de mesure de la résistivité électrique, de préférence par la méthode des quatre pointes ou par la méthode de Van der Pauw.

Ainsi, un avantage procuré est de pouvoir obtenir une caractérisation *operando* de la déformation de la structure utile, c'est-à-dire une mesure au cours de la déformation de la structure utile.

Selon une caractéristique de l'invention :

- les moyens de compression comportent une plaque inférieure et une plaque supérieure, agencées pour enserrer l'empilement ;
- l'empilement comprend :

  une première couche caoutchoutique, intercalée entre la matrice tampon et la plaque supérieure ;
  une deuxième couche caoutchoutique, intercalée entre la plaque inférieure et la structure utile ;
  l'empilement possédant une interface additionnelle entre la structure utile et la deuxième couche caoutchoutique, l'interface additionnelle présentant un plan moyen ;

- les moyens de cisaillement comportent la première couche caoutchoutique, la première couche caoutchoutique étant adaptée pour convertir la force de compression en des forces de cisaillement longitudinales, parallèles au plan moyen de l'interface, s'appliquant à la matrice tampon ;
- la deuxième couche caoutchoutique est adaptée pour convertir la force de compression en des forces de cisaillement longitudinales s'appliquant à la structure utile, dans le plan moyen de l'interface additionnelle.

Ainsi, un avantage procuré par de telles première et deuxième couches caoutchoutiques est d'obtenir un taux de déformation élevée de la structure utile selon un axe perpendiculaire à l'axe de compression.

L'invention a également pour objet un ensemble de fabrication d'une structure utile déformée sur un substrat support, l'ensemble de fabrication comportant :

- un système conforme à l'invention ;
- le substrat support ;

l'empilement étant formé sur le substrat support.

Ainsi, un avantage procuré est de pouvoir obtenir la fabrication d'un substrat avancé ou d'un composant comportant le matériau déformé de la structure utile. La compression de l'empilement permet un glissement de la structure utile sur le substrat support et son collage de manière à maintenir la déformation. Il est également possible d'obtenir un composant accordable comportant le matériau déformé, permettant d'accorder la déformation du matériau durant le fonctionnement du composant. Par exemple, lorsque la structure utile est un cristal photonique, la déformation peut conduire à une modification de la période des nanostructures.

Selon une caractéristique de l'invention, l'empilement comprend une couche d'air, agencée sous la structure utile, et adaptée pour mettre à distance la structure utile du substrat support.

Ainsi, un avantage procuré est d'annuler les forces de friction entre le substrat support et la structure utile pour ne pas être un frein à la déformation de la structure utile.

Selon une caractéristique de l'invention, le substrat support est perméable à l'air ; l'ensemble de fabrication comportant des moyens de circulation, agencés pour faire circuler un flux d'air à partir du substrat support vers la couche d'air de sorte que le flux d'air génère une force de sustentation maintenant en position la structure utile au sein de l'empilement.

Ainsi, un avantage procuré est d'utiliser la couche d'air comme coussin d'air afin de maintenir en position la structure utile au sein de l'empilement.

Selon une caractéristique de l'invention, les moyens de circulation comportent un régulateur, agencé pour réguler le flux d'air circulant au sein de la couche d'air.

Ainsi, un avantage procuré est de pouvoir contrôler la force de sustentation du flux d'air.

L'invention a pour objet un ensemble de fabrication d'une structure utile déformée sur un substrat support, l'ensemble de fabrication comportant :

- un empilement comprenant successivement le substrat support, un film de collage, la structure utile et une matrice tampon ; l'empilement possédant une interface entre la structure utile et la matrice tampon, l'interface présentant un plan moyen ;
- des moyens de compression, agencés pour appliquer à l'empilement une force de compression selon la normale au plan moyen de l'interface ;
- des moyens de cisaillement, agencés pour appliquer à la matrice tampon des forces de cisaillement longitudinales, parallèles au plan moyen de l'interface ;

la matrice tampon étant adaptée pour transmettre les forces de cisaillement à la structure utile, dans le plan moyen de l'interface, de manière à déformer la structure utile.

Selon une caractéristique de l'invention, l'ensemble de fabrication comporte une couche de détachement, intercalée entre le film de collage et la structure utile, la couche de détachement étant adaptée pour détacher le substrat support lorsque la couche de détachement est soumise à un traitement thermique.

Selon une caractéristique de l'invention, le film de collage est réalisé dans un matériau polymère ; l'ensemble de fabrication comportant des moyens d'émission, agencés pour émettre un rayonnement électromagnétique à travers le substrat support de manière à irradier le film de collage, le substrat support étant transparent au rayonnement électromagnétique.

## Brève description des dessins

D'autres caractéristiques et avantages apparaîtront dans l'exposé détaillé de différents modes de réalisation de l'invention, l'exposé étant assorti d'exemples et de références aux dessins joints.

Figure 1a est une vue schématique en coupe d'un système selon l'invention pour équiper un ensemble de caractérisation, avant la compression de l'empilement.

Figure 1b est une vue analogue à la figure 1a, pendant la compression de l'empilement.

Figure 2a est une vue analogue à la figure 1a, illustrant la présence d'une couche anti-glissement ou d'un film de collage intercalé entre la structure utile et la matrice tampon.

Figure 2b est une vue analogue à la figure 2a, pendant la compression de l'empilement.

Figure 3a est une vue schématique en coupe d'un système selon l'invention pour équiper un ensemble de caractérisation, comportant des moyens de cisaillement externes à l'empilement permettant une déformation en tension de la structure utile.

Figure 3b est une vue analogue à la figure 3a, illustrant la présence d'une couche anti-glissement ou d'un film de collage intercalé entre la structure utile et la matrice tampon.

Figure 4a est une vue schématique en coupe d'un système selon l'invention pour équiper un ensemble de caractérisation, illustrant la présence de moyens de cisaillement externes à l'empilement permettant une déformation en compression de la structure utile.

Figure 4b est une vue analogue à la figure 4a, illustrant la présence d'une couche anti-glissement ou d'un film de collage intercalé entre la structure utile et la matrice tampon.

Figure 5a est une vue schématique en coupe d'un ensemble de caractérisation selon l'invention.

Figure 5b est une vue analogue à la figure 5a, illustrant la présence d'une couche anti-glissement ou d'un film de collage intercalé entre la structure utile et la matrice tampon.

Figure 6a est une vue schématique en coupe d'un ensemble de fabrication selon l'invention, avant la compression de l'empilement.

Figure 6b est une vue analogue à la figure 6a, pendant la compression de l'empilement.

Figure 7a est une vue analogue à la figure 6a, illustrant la présence d'une couche anti-glissement ou d'un film de collage intercalé entre la structure utile et la matrice tampon.

Figure 7b est une vue analogue à la figure 7a, pendant la compression de l'empilement.

Figure 8a est une vue schématique en coupe d'un ensemble de fabrication selon l'invention, comportant des moyens de cisaillement externes à l'empilement permettant une déformation en tension de la structure utile.

Figure 8b est une vue analogue à la figure 8a, illustrant la présence d'une couche anti-glissement ou d'un film de collage intercalé entre la structure utile et la matrice tampon.

Figure 9a est une vue schématique en coupe d'un ensemble de fabrication selon l'invention, comportant des moyens de cisaillement rotatifs, externes à l'empilement.

Figure 9b est une vue analogue à la figure 9a, illustrant la présence d'une couche anti-glissement ou d'un film de collage intercalé entre la structure utile et la matrice tampon.

Figure 10 est une vue schématique en coupe d'un empilement d'un système selon l'invention pour équiper un ensemble de caractérisation, illustrant une structure utile composée de motifs enrobés de la matrice tampon.

Figure 11a est une vue schématique en coupe d'un ensemble de fabrication selon l'invention, illustrant la présence d'une couche d'air sous la structure utile.

Figure 11b est une vue schématique en coupe d'un ensemble de fabrication selon l'invention, illustrant la présence d'un coussin d'air sous la structure utile.

Figure 12 est une vue schématique partielle en perspective d'un ensemble de caractérisation selon l'invention, illustrant une déformation de la structure utile avec frustration géométrique.

Figure 13 est une vue schématique partielle en perspective d'un ensemble de fabrication selon l'invention, illustrant une déformation de la structure utile avec frustration géométrique.

Figure 14 est une vue schématique partielle en perspective d'un système selon l'invention, illustrant la présence d'un matériau rigide noyé dans la couche caoutchoutique.

Figure 15a est un ensemble de vues schématiques partielles en coupe d'un système selon l'invention, illustrant l'évolution de la déformation du matériau rigide selon l'axe X de la figure 14 lorsque la structure utile est relaxée.

Figure 15b est un ensemble de vues schématiques partielles en coupe d'un système selon l'invention, illustrant l'évolution de la déformation du matériau rigide selon l'axe Y de la figure 14 lorsque la structure utile est relaxée.

Figure 16a est un graphique représentant en abscisses la force de compression appliquée à l'empilement selon la normale à l'interface, et en ordonnées le taux de déformation de la structure utile selon l'axe X de la figure 14.

Figure 16b est un graphique représentant en abscisses la force de compression appliquée à l'empilement selon la normale à l'interface, et en ordonnées le taux de déformation de la structure utile selon l'axe Y de la figure 14.

Figure 17a est une vue schématique en coupe d'un ensemble de fabrication selon l'invention, illustrant la présence de moyens d'émission d'un rayonnement électromagnétique (infrarouge) destiné à interagir avec le film de collage (e.g. thermoplastique), pour obtenir une interface de glissement entre la structure utile et le film de collage.

Figure 17b est une vue analogue à la figure 17a, illustrant la compression de l'empilement, après l'obtention de l'interface de glissement, pour déformer la structure utile.

Figure 18a est une vue schématique en coupe d'un ensemble de fabrication selon l'invention, illustrant la présence d'un film de collage (e.g. thermodurcissable) présentant une interface de glissement avec la structure utile.

Figure 18b est une vue analogue à la figure 18a, illustrant la présence de moyens d'émission d'un rayonnement électromagnétique (ultraviolet), destiné à interagir avec le film de collage pour figer un état déformé de la structure utile.

Figure 19a est une vue schématique en coupe d'un système selon l'invention, illustrant la présence d'un renfort intégré à la couche caoutchoutique, avant la compression de l'empilement.

Figure 19b est une vue analogue à la figure 19a, pendant la compression de l'empilement.

Figure 20 est une vue schématique en coupe d'un système selon l'invention, illustrant une plaque supérieure présentant une surface non plane, et une couche caoutchoutique surmontée d'une couche de polymère présentant une surface non plane.

Il est à noter que les dessins décrits ci-avant sont schématiques, et ne sont pas nécessairement à l'échelle par souci de lisibilité et pour en simplifier leur compréhension. Les coupes sont effectuées selon la normale au plan moyen de l'interface entre la structure utile et la matrice tampon.

**Exposé détaillé des modes de réalisation**

Les éléments identiques ou assurant la même fonction porteront les mêmes références pour les différents modes de réalisation, par souci de simplification.

*Système*

Un objet de l'invention est un système pour déformer une structure utile 1, comportant :

- un empilement comprenant successivement la structure utile 1 et une matrice tampon 2 ; l'empilement possédant une interface entre la structure utile 1 et la matrice tampon 2, l'interface présentant un plan moyen ;
- des moyens de compression, agencés pour appliquer à l'empilement une force de compression F selon la normale Z'-Z au plan moyen de l'interface ;
- des moyens de cisaillement, agencés pour appliquer à la matrice tampon 2 des forces de cisaillement f longitudinales, parallèles au plan moyen de l'interface ;

la matrice tampon 2 étant adaptée pour transmettre les forces de cisaillement f à la structure utile 1, dans le plan moyen de l'interface, de manière à déformer la structure utile 1.

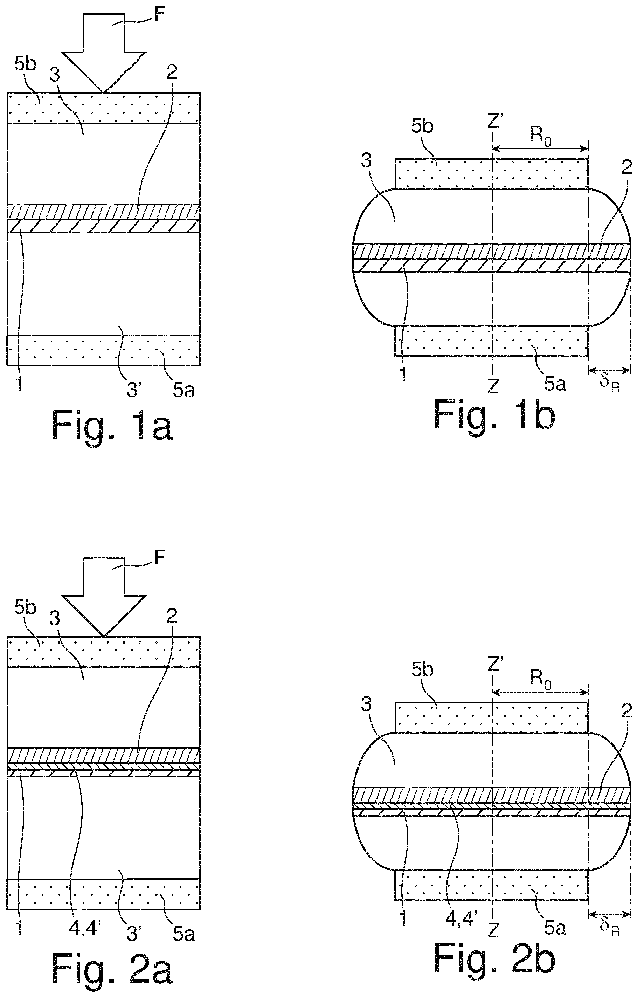

L'allongement $\delta_R$ (ou le raccourcissement) de la structure utile 1 par rapport à sa longueur initiale $R_0$ selon un axe longitudinal des forces de cisaillement f est illustré aux figures 1b, 2b, 6b et 7b.

*Empilement*

La structure utile 1 possède un taux de déformation à la rupture, noté $\tau_{R1}$. La structure utile 1 peut être choisie parmi une :

- une structure à base d'un matériau de type semiconducteur ;
- une structure à base d'un matériau de type pérovskite ;
- une structure de type cristal photonique ;
- une structure à base d'un matériau composite ;
- un cristal ;
- un métal ;
- un polymère ;
- une céramique ;
- une chaux ;
- un ciment.

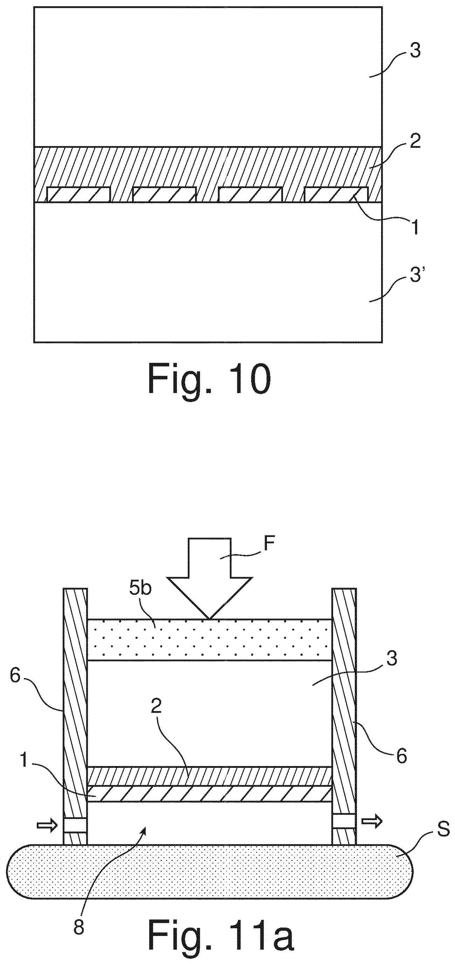

Le matériau à déformer de la structure utile 1 est solide. A titre d'exemples non limitatifs, la structure utile 1 peut être réalisée sous la forme d'un film fin ou épais, d'un film structuré en motifs (comme illustré à la figure 10), d'un réseau de fils nanométriques, d'un matériau bidimensionnel dit 2D comportant une à quelques monocouches atomiques. Un avantage procuré par un film structuré en motifs permet d'augmenter la limite de déformation élastique. En effet, la limite de déformation élastique d'une structure dépend de sa géométrie. L'aire de la section efficace (surface de coupe normale à l'axe Z'-Z de la force F de compression) varie de manière inversement corrélée à la limite de déformation élastique. La structure utile 1 présente avantageusement une géométrie compatible avec les microtechnologies/nanotechnologies. Autrement dit, la structure utile 1 peut présenter une épaisseur comprise entre quelques nm et quelques $\mu$m. Par « épaisseur », on entend la dimension selon la normale Z'-Z au plan moyen de l'interface entre la structure utile 1 et la matrice tampon 2. Toutefois, la structure utile 1 peut être macroscopique. Lorsque la structure utile 1 est macroscopique, sa surface peut présenter plusieurs dizaines de cm$^2$. A titre d'exemple non limitatif, la structure utile 1 peut être une couche de silicium présentant une épaisseur comprise entre 200 nm et 2 $\mu$m.

La matrice tampon 2 possède avantageusement un module d'Young supérieur ou égal à 1 GPa. La matrice tampon 2 possède un taux de déformation à la rupture, noté $\tau_{R2}$, vérifiant avantageusement $\tau_{R2} > \tau_{R1}$. La matrice tampon 2 est avantageusement réalisée dans un matériau choisi parmi :

- un polymère, de préférence un polyimide, le polycarbonate, un polyéthérimide, un polyamide-imide, le polyéthylène, un verre, le polyétheréthercétone, le polypropylène, le polyméthacrylate de méthyle, le polyéthersulfone, le polychlorure de vinyle, le polystyrène, le polytéréphtalate d'éthylène ;
- une céramique, de préférence SiN, SiC, Al$_2$O$_3$.

L'empilement comprend avantageusement une couche caoutchoutique 3 ; la matrice tampon 2 étant intercalée entre la structure utile 1 et la couche caoutchoutique 3. La couche caoutchoutique 3 est avantageusement réalisée dans un matériau choisi parmi :

- un polymère de type silicone, comprenant de préférence le polydiméthylsiloxane (PDMS) ;
- l'éthylène-acétate de vinyle ;
- un polyuréthane ;
- un polyacrylique ;
- le butadiène ;

- un composé comprenant un groupement butyle ;
- un caoutchouc de type EPDM ;
- un fluoroélastomère, notamment un perfluoroélastomère ;
- l'isoprène ;
- un composé comprenant un groupement nitrile ;
- le polychloroprène ;
- le styrène-butadiène.

Lorsque la matrice tampon 2 est un film de polyimide et la couche caoutchoutique 3 est réalisée en PDMS, la couche caoutchoutique 3 peut être collée sur la matrice tampon 2 à l'aide du réactif unique 3-mercaptopropyltriméthoxysilane (MPTMS) à température ambiante. Lorsque la structure utile 1 est une couche de silicium, le film de polyimide peut être collé sur la structure utile 1 à l'aide d'un adhésif (e.g. HD3007 ou HD3008 commercialisés par HD Microsystems™).

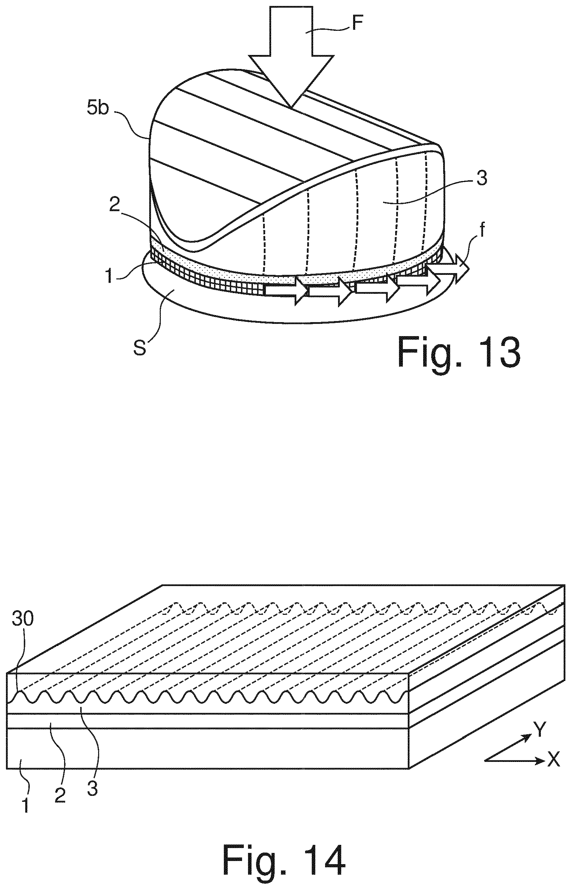

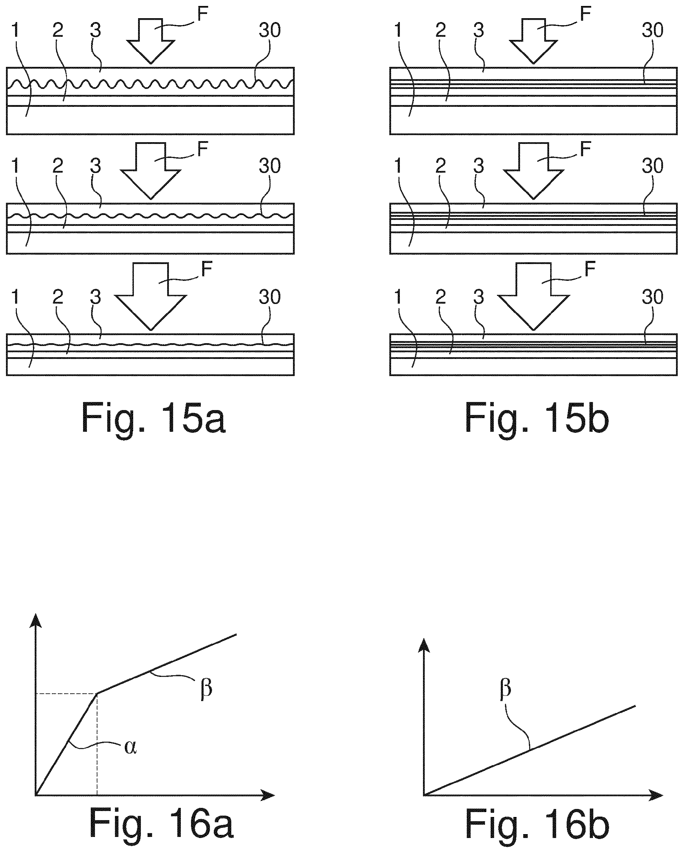

Comme illustré à la figure 14 et aux figures 15a et 15b, l'empilement peut comporter un matériau rigide 30, noyé dans la couche caoutchoutique 3. Par « rigide », on entend que le matériau rigide 30 possède un module d'Young supérieur ou égal à 100 MPa, de préférence supérieur ou égal à 1 GPa. Le matériau rigide 30 est géométriquement adapté de manière à présenter une résistance en traction différenciée selon les axes X et Y, comme illustré aux figures 16a et 16b, à partir d'un seuil de force de compression F appliquée à l'empilement selon la normale Z'-Z au plan moyen de l'interface. En effet, comme illustré à la figure 16a, à partir du seuil de de force de compression F, la résistance en traction selon l'axe X correspond à la somme des coefficients $\alpha$ et $\beta$, tandis que la résistance en traction selon l'axe Y correspond au coefficient $\beta$, comme illustré à la figure 16b. A titre d'exemple non limitatif, le matériau rigide 30 peut être un polymère, de préférence un polyimide lorsque la couche caoutchoutique 3 est réalisée en PDMS. Lorsque la structure utile 1 est comprimée verticalement, la déformation latérale qui en résulte diffère selon chacun des axes X et Y en raison de la géométrie des ondulations du matériau rigide 30. Le matériau rigide 30 ondulé ne modifie pas la résistance à l'allongement selon l'axe X tant que le matériau rigide 30 n'est pas « déplié », alors que le matériau rigide 30 offre une résistance à l'allongement selon l'axe Y indépendamment de son ondulation. A partir d'un certain taux de compression, les ondulations du matériau rigide 30 disparaissent. La résistance à l'allongement devient comparable selon les deux axes X et Y. Comme illustré aux figures 16a et 16b, la déformation est d'abord rapide selon X puisque, selon cet axe, le matériau rigide 30 se déplie sans offrir de résistance. Dès que le matériau rigide 30 est déplié sous l'effet de la pression verticale, la résistance du matériau rigide 30 apparaît selon l'axe X. La pente devient alors identique à celle décrivant la variation selon l'axe Y dont la résistance à la déformation n'est pas liée à la présence ou à l'état des ondulations.

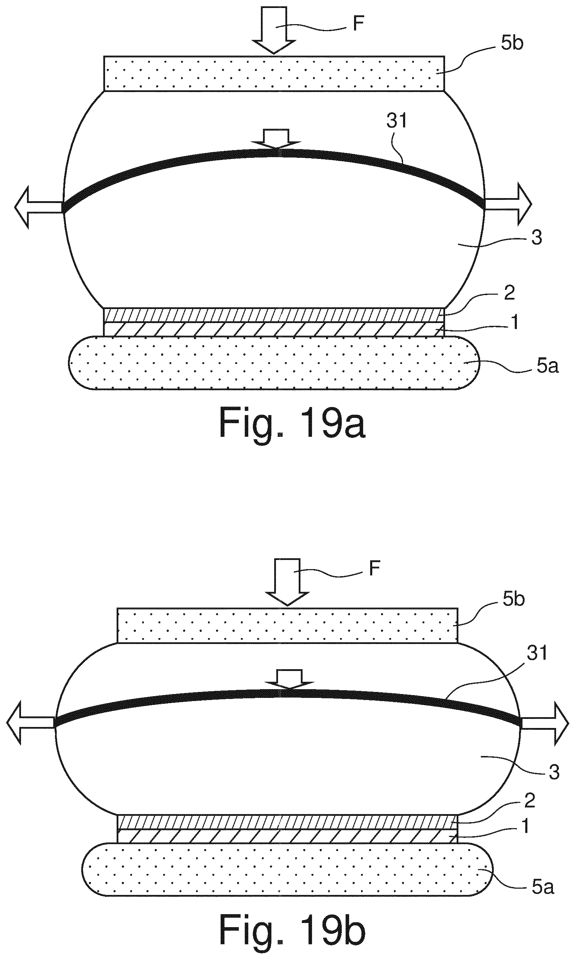

Comme illustré aux figures 19a et 19b, l'empilement peut comporter un renfort 31, réalisé dans un matériau rigide, et intégré à la couche caoutchoutique 3, par exemple par moulage. Le renfort 31 peut présenter un module d'Young de l'ordre de 1 GPa. Le renfort 31 peut présenter une épaisseur de quelques centaines de $\mu$m. Le renfort 31 présente une surface non-plane. Le renfort 31 peut avoir un profil différent selon les axes définissant un plan parallèle au plan moyen de l'interface entre la structure utile 1 et la matrice tampon 2. Sous l'action de la force de compression F, le renfort 31 s'aplatit de manière à favoriser la déformation en tension de la matrice tampon 2 et par là-même de la structure utile 1. Le renfort 31 peut présenter une épaisseur variable (i.e. dimension selon la normale au plan moyen de l'interface entre la matrice tampon 2 et la structure utile 1) de manière à permettre une déformation non homogène.

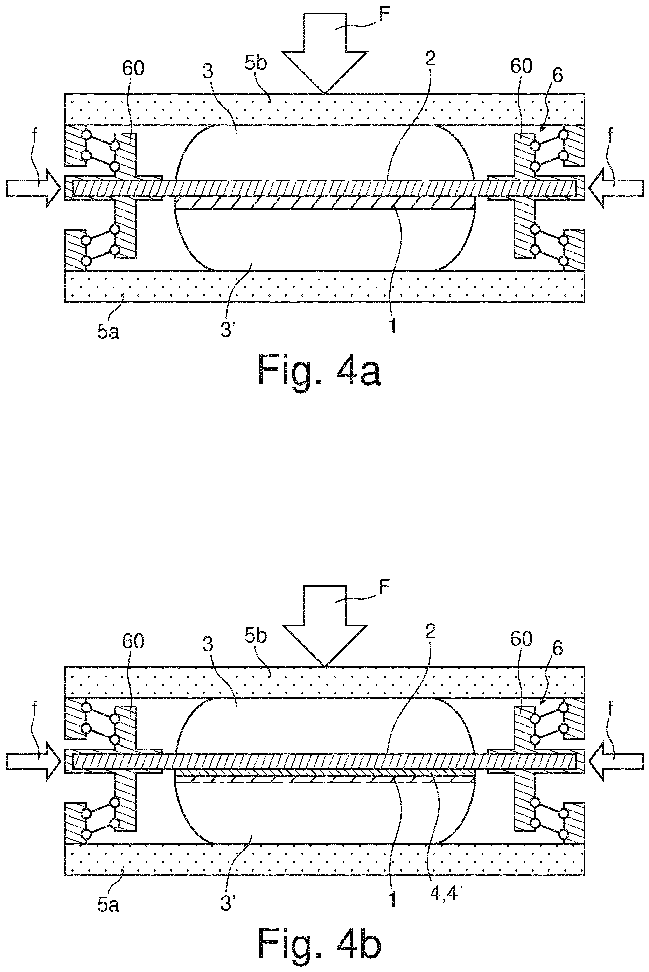

Comme illustré aux figures 2a, 2b, 3b, 4b, 5b, 7a, 7b, 8b et 9b, l'empilement peut comprendre une couche anti-glissement 4, intercalée entre la structure utile 1 et la matrice tampon 2, la couche anti-glissement 4 possédant un coefficient de friction adapté pour maintenir en position la structure utile 1 au sein de l'empilement. A titre d'alternative, l'empilement peut comprendre un film de collage 4', intercalé entre la structure utile 1 et la matrice tampon 2.

*Moyens de compression*

Les moyens de compression peuvent comporter une plaque inférieure 5a et une plaque supérieure 5b, agencées pour enserrer l'empilement.

Les plaques inférieure 5a et supérieure 5b sont rigides. Par « rigides », on entend que les plaques inférieure 5a et supérieure 5b possèdent un module d'Young supérieur ou égal à 100 MPa, de préférence supérieur ou égal à 1 GPa.

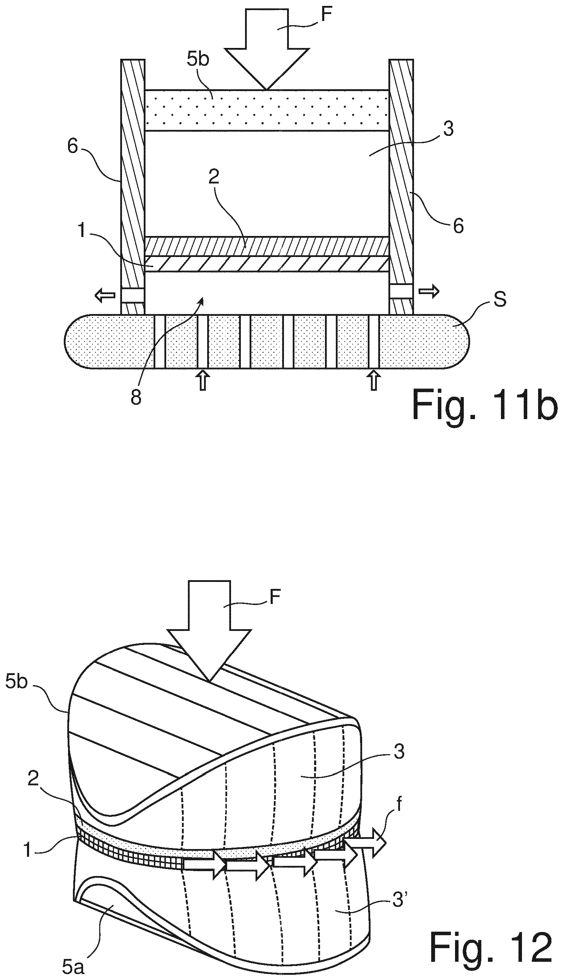

Comme illustré aux figures 12 et 13, la plaque supérieure 5b peut présenter une surface de contact non-plane avec la couche caoutchoutique 3, la surface de contact non-plane étant géométriquement adaptée de sorte que la couche caoutchoutique 3 convertit la force de compression F en des forces de cisaillement f longitudinales, parallèles au plan moyen de l'interface, s'appliquant de manière anisotrope à la matrice tampon 2. On parle alors de déformation de la structure utile 1 avec frustration géométrique.

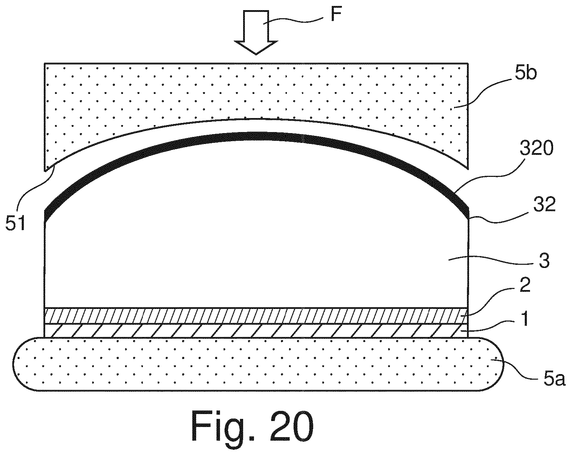

Comme illustré à la figure 20, la couche caoutchoutique 3 peut être surmontée d'une couche de polymère 32 présentant une surface 320 non-plane. La plaque supérieure 5b peut présenter une surface 51 non-plane, destinée à être en contact avec la couche de polymère 32. La surface 320 non-plane de la couche de polymère 32 peut présenter une forme différente de la surface 51 non-plane de la plaque supérieure 5b. Les formes différentes de la surface 51 non-plane de la plaque supérieure 5b et de la surface 320 non-plane de la couche de polymère 32 peuvent être adaptées pour obtenir une dissymétrie de la déformation engendrée, qui peut être par exemple uniaxiale, compressive selon un axe, ou en tension selon un autre axe. La couche de polymère 32, formée sur la couche caoutchoutique 3, présente un module d'Young strictement supérieur au module d'Young de la couche caoutchoutique 3.

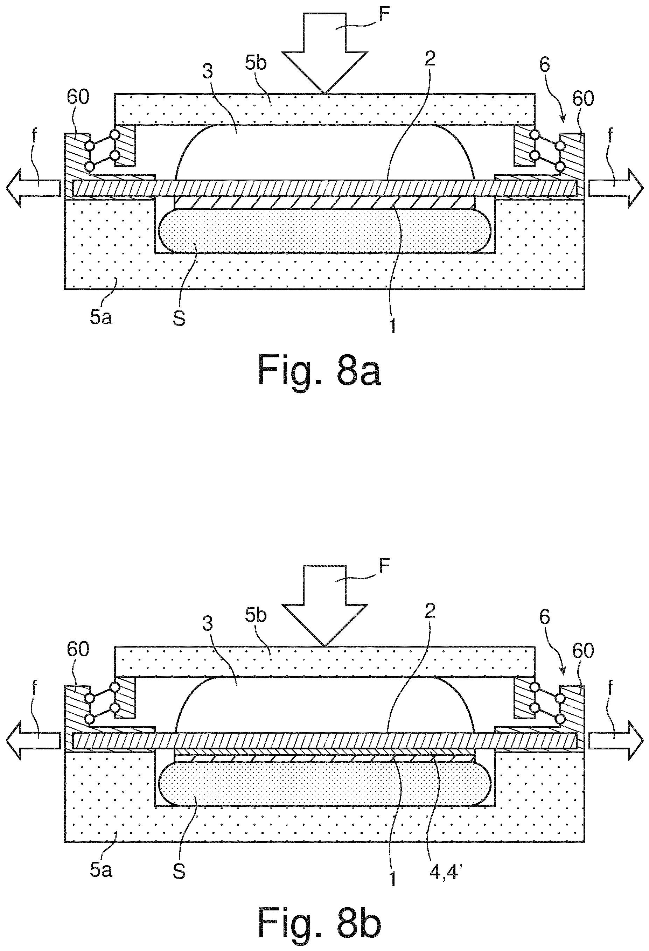

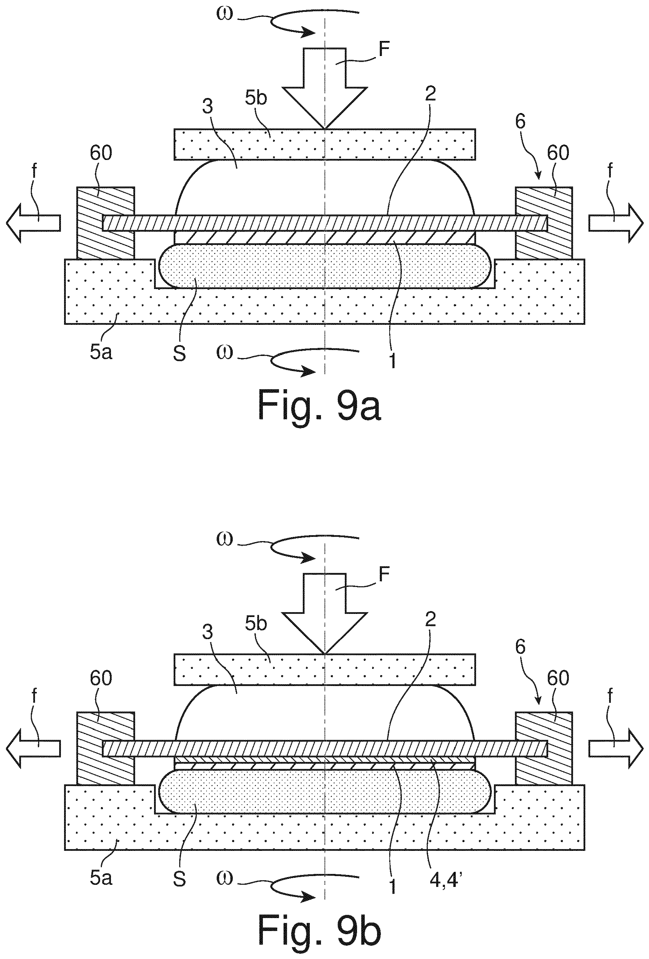

Comme illustré aux figures 8a, 8b, 9a et 9b, la plaque inférieure 5a peut être réalisée sous la forme d'un châssis adapté pour recevoir l'empilement.

### Moyens de cisaillement

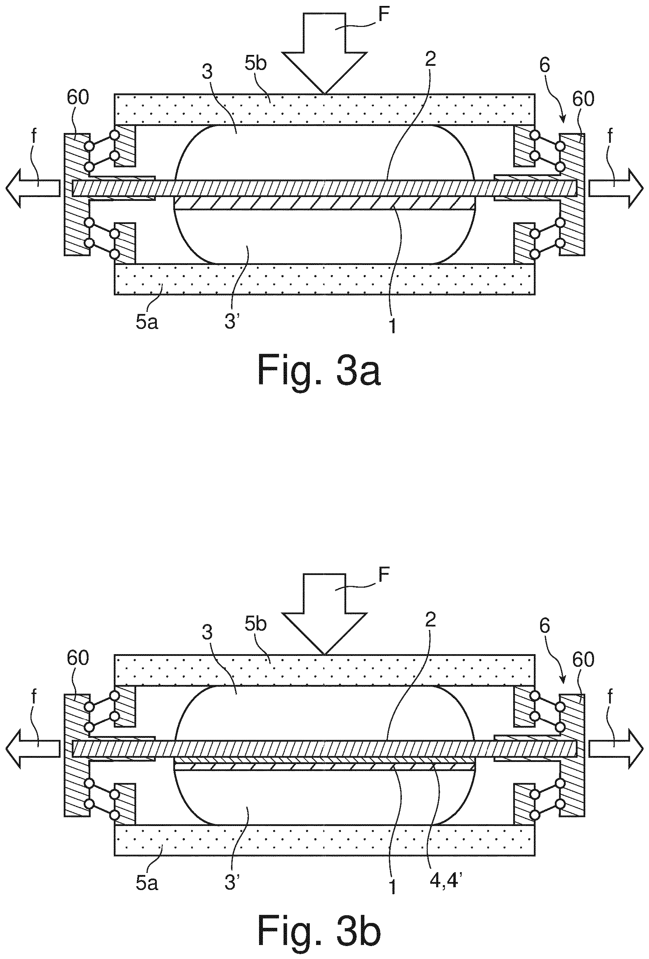

Comme illustré aux figures 3a, 3b, 4a, 4b, 8a, 8b, 9a et 9b, les moyens de cisaillement peuvent comporter un organe de préhension 6 de la matrice tampon 2, mobile en translation selon une direction longitudinale, parallèle au plan moyen de l'interface. Les moyens de cisaillement comportent avantageusement un parallélogramme articulé, agencé pour mouvoir l'organe de préhension 6 en translation selon la direction longitudinale. L'organe de préhension 6 est avantageusement mobile en rotation autour d'un axe de rotation ω perpendiculaire au plan moyen de l'interface. L'organe de préhension 6 peut comporter deux bras de préhension 60, agencés aux extrémités latérales de la couche tampon 2. Comme illustré aux figures 8a, 8b, 9a et 9b, l'organe de préhension 6 peut être monté sur un châssis 5a. Le châssis 5a est avantageusement mobile en rotation autour d'un axe de rotation ω perpendiculaire au plan moyen de l'interface. Il est alors possible de déformer la structure utile 1 grâce à la force centrifuge obtenue par la rotation. L'ajout de poids en périphérie de la matrice tampon 2 permet d'augmenter la force centrifuge. De tels moyens de cisaillement sont externes à l'empilement.

Les moyens de cisaillement comportent avantageusement la couche caoutchoutique 3, la couche caoutchoutique 3 étant adaptée pour convertir la force de compression F en des forces de cisaillement f longitudinales, parallèles au plan moyen de l'interface, s'appliquant à la matrice tampon 2. De tels moyens de cisaillement sont internes à l'empilement, et peuvent coexister avec des moyens de cisaillement externes à l'empilement, ce qui permet d'envisager des déformations biaxiales (éventuellement anisotropes) de la structure utile 1 dans le plan moyen de l'interface entre la structure utile 1 et la matrice tampon 2. Il est également possible d'utiliser uniquement des moyens de cisaillement internes à l'empilement, et de s'affranchir de moyens de cisaillement externes à l'empilement.

Les moyens de cisaillement peuvent comporter une structure rigide, agencée autour de la couche caoutchoutique 3 pour contrôler la déformation de la couche caoutchoutique 3. Plus précisément, la structure rigide est géométriquement adaptée pour contrôler la déformation de la couche caoutchoutique 3 dans un plan parallèle au plan moyen de l'interface, lors de la conversion de la force de compression F en des forces de cisaillement f longitudinales, parallèles au plan moyen de l'interface, s'appliquant à la matrice tampon 2. Une telle structure rigide permet d'empêcher, dans certaines directions, des déformations biaxiales de la structure utile 1, dans le plan moyen de l'interface entre la structure utile 1 et la matrice tampon 2. A titre d'exemple non limitatif, la structure rigide peut être réalisée à l'aide d'un moule. Par « rigide », on entend que la structure rigide possède un module d'Young supérieur ou égal à 100 MPa, de préférence supérieur ou égal à 1 GPa.

### Equipements additionnels

Le système peut comporter une enceinte adaptée pour recevoir l'empilement. L'enceinte peut comporter des parois adaptées pour autoriser un accès aux moyens de compression, et le cas échéant aux moyens de cisaillement externes à l'empilement, afin de pouvoir les actionner. Une telle enceinte permet d'appliquer un traitement thermique à l'empilement (e.g. une fonction d'étuve), par exemple pour obtenir un point de fonctionnement particulier de la structure utile 1. A titre illustratif, la conductivité électrique de la structure utile 1 peut varier en fonction de la température.

Le système comporte avantageusement des parois latérales, fixes, agencées pour enserrer latéralement la couche caoutchoutique 3. De telles parois latérales peuvent appartenir à un moule. De telles parois latérales permettent de contrôler la déformation latérale de la couche caoutchoutique 3. On parle de déformation frustrée. Il est également possible de prévoir un lubrifiant entre les parois latérales et l'empilement.

### Ensemble de caractérisation

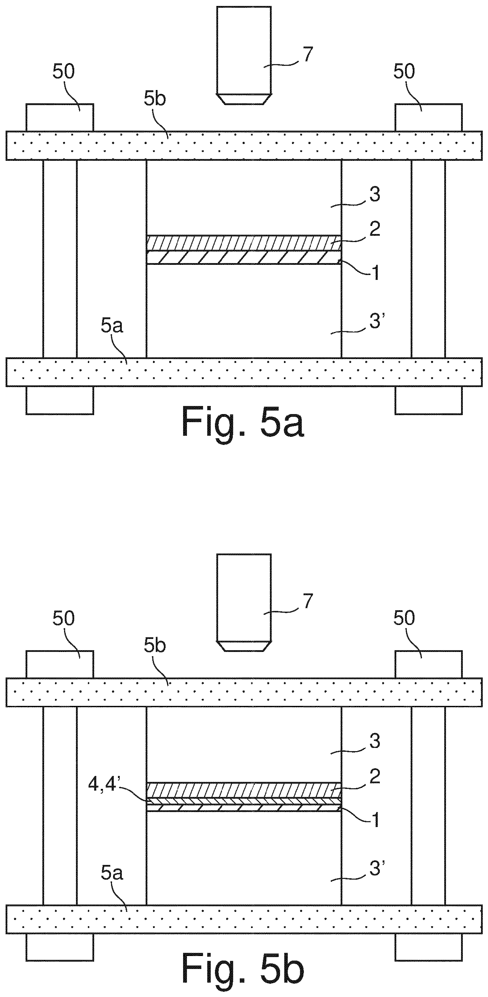

Comme illustré aux figures 5a et 5b, un objet de l'invention est un ensemble de caractérisation d'une structure utile 1 à déformer, comportant :

- un système conforme à l'invention ;
- un instrument 7 de caractérisation, agencé pour mesurer la déformation de la structure utile 1, l'instrument 7 de caractérisation étant de préférence choisi parmi :

un spectroscope, de préférence un diffractomètre à rayons X, un spectromètre Raman, un spectroscope de photoluminescence, un spectroscope de réflectance ;
un instrument de mesure de la résistivité électrique, de préférence par la méthode des quatre pointes ou par la méthode de Van der Pauw.

D'autres techniques de spectrométrie sont possibles : absorption optique, absorption des rayons X etc.

Selon un mode de réalisation :

- les moyens de compression comportent une plaque inférieure 5a et une plaque supérieure 5b, agencées pour enserrer l'empilement ;
- l'empilement comprend :

  une première couche caoutchoutique 3, intercalée entre la matrice tampon 2 et la plaque supérieure 5b ;
  une deuxième couche caoutchoutique 3', intercalée entre la plaque inférieure 5a et la structure utile 1 ;
  l'empilement possédant une interface additionnelle entre la structure utile 1 et la deuxième couche caoutchoutique 3', l'interface additionnelle présentant un plan moyen ;

- les moyens de cisaillement comportent la première couche caoutchoutique 3, la première couche caoutchoutique 3 étant adaptée pour convertir la force de compression F en des forces de cisaillement f longitudinales, parallèles au plan moyen de l'interface, s'appliquant à la matrice tampon 2 ;
- la deuxième couche caoutchoutique 3' est adaptée pour convertir la force de compression F en des forces de cisaillement f longitudinales s'appliquant à la structure utile 1, dans le plan moyen de l'interface additionnelle.

A titre d'exemples non limitatifs, la plaque supérieure 5b peut être réalisée en polyméthacrylate de méthyle (PMMA), et la plaque inférieure 5a peut être réalisée dans un matériau métallique tel que Al. Le PMMA est avantageux en termes de rigidité et de transparence (notamment dans le domaine visible). Comme illustré aux figures 5a et 5b, les moyens de compression peuvent comporter deux vis de serrage 50 dont le couple de serrage peut être mesuré à l'aide d'un tournevis dynamométrique.

Les première et deuxième couches caoutchoutiques 3, 3' sont avantageusement réalisées dans un matériau choisi parmi :

- un polymère de type silicone, comprenant de préférence le polydiméthylsiloxane (PDMS) ;
- l'éthylène-acétate de vinyle ;
- un polyuréthane ;
- un polyacrylique ;
- le butadiène ;
- un composé comprenant un groupement butyle ;
- un caoutchouc de type EPDM ;
- un fluoroélastomère, notamment un perfluoroélastomère ;
- l'isoprène ;
- un composé comprenant un groupement nitrile ;
- le polychloroprène ;
- le styrène-butadiène.

Lorsque les première et deuxième couches caoutchoutiques 3, 3' sont réalisées en PDMS, il n'est pas nécessaire de les coller respectivement aux plaques supérieure 5b et inférieure 5a. En effet, le PDMS, du fait de son faible module d'Young, possède un coefficient de friction très élevé.

Comme illustré à la figure 12, la plaque inférieure 5a peut présenter une surface de contact non-plane avec la deuxième couche caoutchoutique 3', la surface de contact non-plane étant géométriquement adaptée de sorte que la deuxième couche caoutchoutique 3' convertit la force de compression F en des forces de cisaillement f longitudinales, s'appliquant de manière anisotrope à la structure utile 1, dans le plan moyen de l'interface additionnelle.

### Ensemble de fabrication n°1

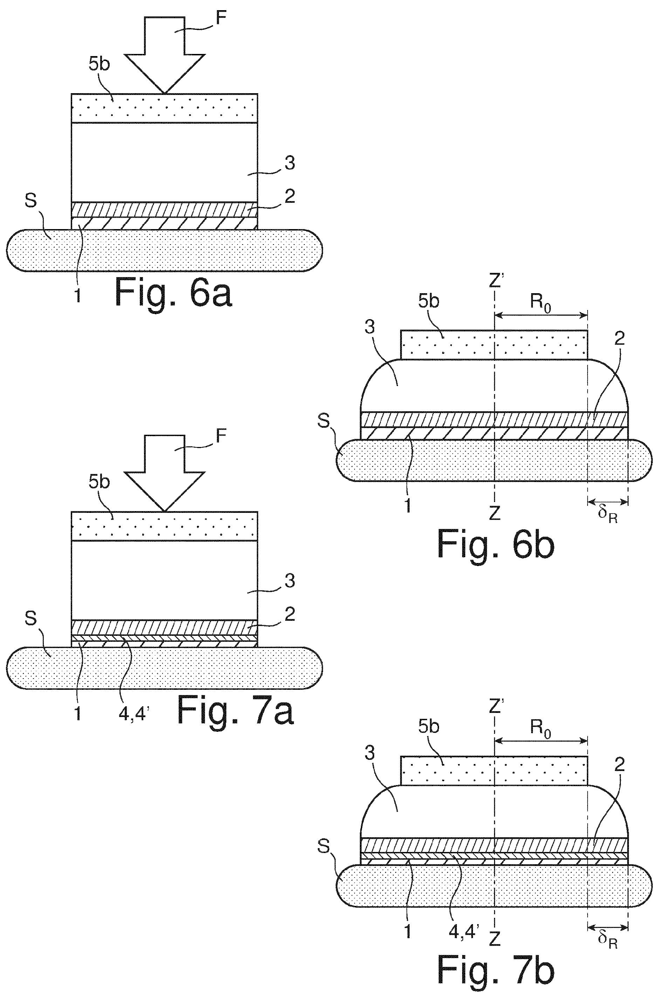

Comme illustré aux figures 6a, 6b, 7a, 7b, 8a, 8b, 9a, 9b, 11a et 11b, un objet de l'invention est un ensemble de fabrication d'une structure utile 1 déformée sur un substrat support S, l'ensemble de fabrication comportant :

- un système conforme à l'invention ;

- le substrat support S ;

l'empilement étant formé sur le substrat support S.

A titre d'exemples non limitatifs, le substrat support S peut être réalisé dans un matériau choisi parmi Si, Ge, $Al_2O_3$ (saphir), un verre.

Comme illustré aux figures 11a et 11b, l'empilement peut comprendre une couche d'air 8, agencée sous la structure utile 1, et adaptée pour mettre à distance la structure utile 1 du substrat support S. L'organe de préhension 6 de la matrice tampon 2 s'étend avantageusement sur les bords latéraux de l'empilement de manière à délimiter la couche d'air 8. Après déformation de la structure utile 1, l'air peut être retiré de la couche d'air 8, par exemple par des moyens de mise sous vide, et ce afin d'obtenir une adhésion de l'empilement sur le substrat support S.

Selon un mode de réalisation illustré à la figure 11b, le substrat support S est perméable à l'air, et l'ensemble de fabrication comporte des moyens de circulation, agencés pour faire circuler un flux d'air à partir du substrat support S vers la couche d'air 8 de sorte que le flux d'air génère une force de sustentation maintenant en position la structure utile 1 au sein de l'empilement. Les moyens de circulation comportent avantageusement un régulateur, agencé pour réguler le flux d'air circulant au sein de la couche d'air 8. Le régulateur peut comporter un compresseur d'air.

En variante de la couche d'air 8, le substrat support S peut comporter un film de collage temporaire sur lequel est formé l'empilement. Le film de collage temporaire peut être réalisé dans un matériau dont le changement de phase peut être contrôlé. Le film de collage temporaire peut subir un traitement thermique adapté pour éviter un collage définitif et autoriser un glissement longitudinal (dans le plan moyen de l'interface entre le film de collage temporaire et la structure utile 1) de la structure utile 1.

A cet égard, l'ensemble de fabrication peut comporter une enceinte adaptée pour recevoir le système et le substrat support S. L'enceinte peut comporter des parois adaptées pour autoriser un accès aux moyens de compression, et le cas échéant aux moyens de cisaillement externes à l'empilement, afin de pouvoir les actionner. Une telle enceinte permet notamment d'appliquer un traitement thermique au film de collage temporaire (e.g. un polyimide thermoplastique), le traitement thermique étant adapté pour modifier les propriétés mécaniques du film de collage temporaire de manière à autoriser un glissement longitudinal de la structure utile 1 pour la déformer. Un abaissement de la température du traitement thermique permet de polymériser à nouveau le film de collage temporaire, et de figer l'état déformé de la structure utile 1. Selon une variante de réalisation, un traitement thermique (e.g. à une température comprise entre 80°C et 120°C) est appliqué au substrat support S et au film de collage temporaire pour limiter l'énergie d'adhésion entre la structure utile 1 et le film de collage temporaire, et ce afin d'obtenir une interface de glissement entre la structure utile 1 et le film de collage temporaire. Lorsque la structure utile 1 est déformée, le collage entre la structure utile 1 et le film de collage temporaire est optimisé, soit en refroidissant l'ensemble à température ambiante (collage direct), soit en chauffant l'ensemble à 300°C tout en exerçant une pression de collage (thermocompression).

Après que la structure utile 1 est déformée sur le substrat support S, les éléments recouvrant la structure utile (e.g. couche anti-glissement 4, matrice tampon 2, couche caoutchoutique 3) peuvent être retirés de manière à mettre à nu la structure utile 1. Puis la structure utile 1 déformée peut être transférée sur un substrat final, par exemple via un collage oxyde-oxyde (e.g. $SiO_2$), avec l'utilisation éventuelle d'un plasma (e.g. O, $O_2$). Le substrat support S est ensuite retiré afin d'achever le transfert de la structure utile 1 déformée.

### *Ensemble de fabrication n°2*

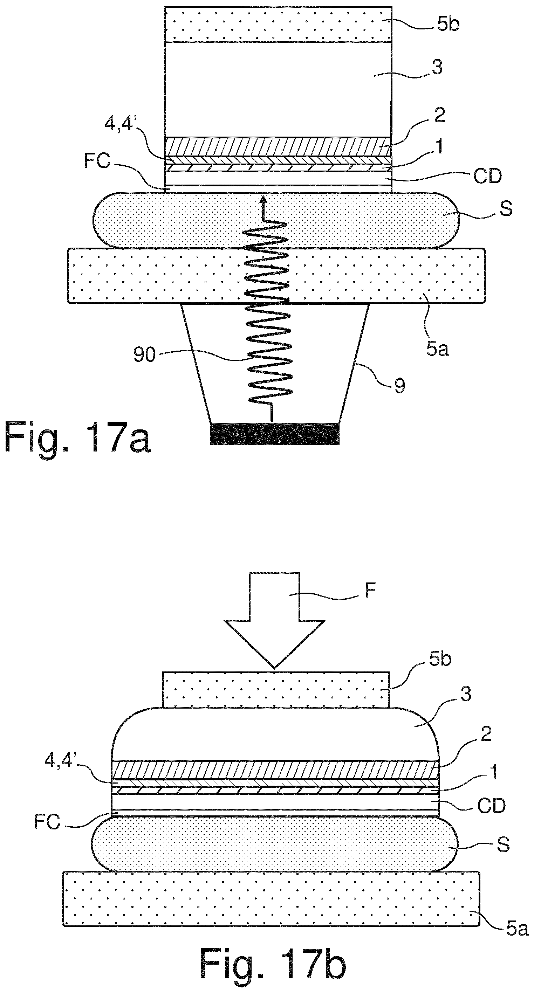

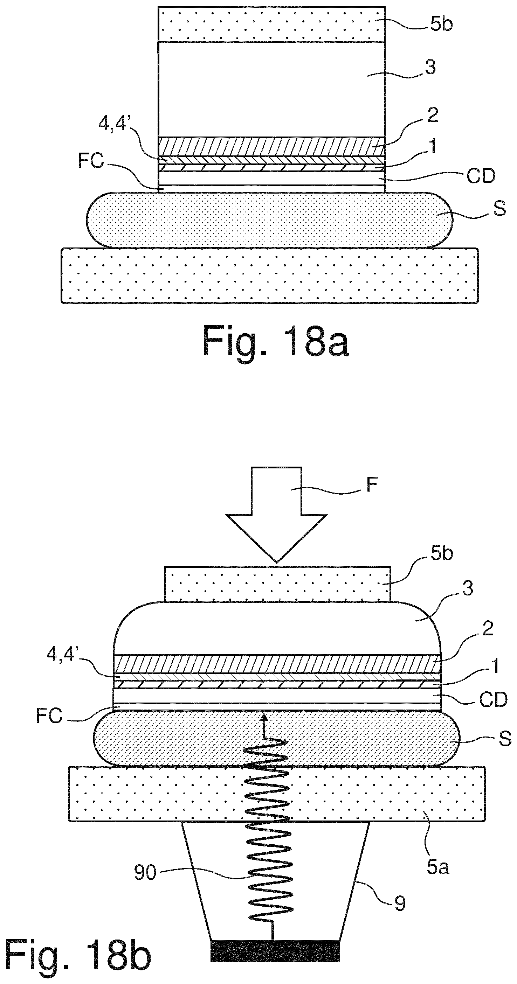

Comme illustré aux figures 17a, 17b, 18a, 18b, un objet de l'invention est un ensemble de fabrication d'une structure utile 1 déformée sur un substrat support S, l'ensemble de fabrication comportant :

- un empilement comprenant successivement le substrat support S, un film de collage FC, la structure utile 1 et une matrice tampon 2 ; l'empilement possédant une interface entre la structure utile 1 et la matrice tampon 2, l'interface présentant un plan moyen ;
- des moyens de compression, agencés pour appliquer à l'empilement une force de compression F selon la normale Z'-Z au plan moyen de l'interface ;
- des moyens de cisaillement, agencés pour appliquer à la matrice tampon 2 des forces de cisaillement f longitudinales, parallèles au plan moyen de l'interface ;

la matrice tampon 2 étant adaptée pour transmettre les forces de cisaillement f à la structure utile 1, dans le plan moyen de l'interface, de manière à déformer la structure utile 1.

L'empilement peut être obtenu à partir d'un substrat support S de type SoP (« *Semiconductor-on-Polymer»* en langue anglaise), sur lequel est formée la matrice tampon 2. La couche semi-conductrice 2 du substrat support S de type SoP forme la structure utile 1. La couche de polymère du substrat support S de type SoP forme le film de collage FC.

L'empilement peut comporter un film de collage 4', intercalé entre la structure utile 1 et la matrice tampon 2, possédant une fonction d'anti-glissement.

Les moyens de compression peuvent comporter une plaque inférieure 5a et une plaque supérieure 5b, agencées pour enserrer l'empilement.

L'ensemble de fabrication peut comporter une couche de détachement CD, intercalée entre le film de collage FC et la structure utile 1, la couche de détachement CD étant adaptée pour détacher le substrat support S lorsque la couche de détachement CD est soumise à un traitement thermique. A titre d'exemple non limitatif, la couche de détachement CD peut être réalisée dans un matériau thermoplastique. Selon une alternative, le film de collage FC possède intrinsèquement une fonction de détachement.

Le film de collage FC est avantageusement réalisé dans un matériau polymère. L'ensemble de fabrication peut comporter des moyens d'émission 9, agencés pour émettre un rayonnement électromagnétique 90 à travers le substrat support S de manière à irradier le film de collage FC, le substrat support S étant transparent au rayonnement électromagnétique 90. A titre d'exemple non limitatif, le substrat support S peut être réalisé en verre ou en saphir.

Selon un mode de réalisation, le film de collage FC est réalisé dans un polymère thermoplastique (e.g. un polyimide), et les moyens d'émission 9 sont adaptés pour émettre un rayonnement électromagnétique 90 infrarouge, la longueur d'onde pouvant être de l'ordre de 1 $\mu$m. Le polymère thermoplastique est opaque aux infrarouges. Ce mode de réalisation permet d'obtenir un chauffage dit « à mur froid » du film de collage FC. Le rayonnement électromagnétique 90 passe au travers des matériaux transparents aux infrarouges de l'empilement, et chauffe de manière ciblée les matériaux opaques aux infrarouges de l'empilement. Les moyens d'émission peuvent comporter une lampe 9 infrarouge, agencée sous la plaque inférieure 5a. Les moyens d'émission 9 sont désactivés afin de figer l'état déformé de la structure utile 1.

Selon un mode de réalisation, le film de collage FC est réalisé dans un polymère thermodurcissable (e.g. une résine époxy), et les moyens d'émission 9 sont adaptés pour émettre un rayonnement électromagnétique 90 ultraviolet. Le rayonnement électromagnétique 90 ultraviolet est activé pour polymériser le film de collage FC afin de figer l'état déformé de la structure utile 1.

L'invention est définie par le jeu de revendications annexé.

## Revendications

**1.** Système pour déformer une structure utile (1), comportant :

- un empilement comprenant successivement la structure utile (1) et une matrice tampon (2) ; l'empilement possédant une interface entre la structure utile (1) et la matrice tampon (2), l'interface présentant un plan moyen ;
- des moyens de compression, agencés pour appliquer à l'empilement une force de compression (F) selon la normale (Z'-Z) au plan moyen de l'interface ;
- des moyens de cisaillement, agencés pour appliquer à la matrice tampon (2) des forces de cisaillement (f) longitudinales, parallèles au plan moyen de l'interface ;

la matrice tampon (2) étant adaptée pour transmettre les forces de cisaillement (f) à la structure utile (1), dans le plan moyen de l'interface, de manière à déformer la structure utile (1).

**2.** Système selon la revendication 1, dans lequel les moyens de cisaillement comportent un organe de préhension (6) de la matrice tampon (2), mobile en translation selon une direction longitudinale, parallèle au plan moyen de l'interface.

**3.** Système selon la revendication 2, dans lequel les moyens de cisaillement comportent un parallélogramme articulé, agencé pour mouvoir l'organe de préhension (6) en translation selon la direction longitudinale.

**4.** Système selon la revendication 2 ou 3, dans lequel l'organe de préhension (6) est mobile en rotation autour d'un axe de rotation ($\omega$) perpendiculaire au plan moyen de l'interface.

**5.** Système selon l'une des revendications 1 à 4, dans lequel l'empilement comprend une couche caoutchoutique (3) ; la matrice tampon (2) étant intercalée entre la structure utile (1) et la couche caoutchoutique (3) ; et les moyens de cisaillement comportent la couche caoutchoutique (3), la couche caoutchoutique (3) étant adaptée pour convertir la force de compression (F) en des forces de cisaillement (f) longitudinales, parallèles au plan moyen de l'interface, s'appliquant à la matrice tampon (2).

**6.** Système selon la revendication 5, dans lequel la couche caoutchoutique (3) est réalisée dans un matériau choisi parmi :

- un polymère de type silicone, comprenant de préférence le polydiméthylsiloxane ;
- l'éthylène-acétate de vinyle ;
- un polyuréthane ;
- un polyacrylique ;
- le butadiène ;
- un composé comprenant un groupement butyle ;
- un caoutchouc de type EPDM ;
- un fluoroélastomère, notamment un perfluoroélastomère ;
- l'isoprène ;
- un composé comprenant un groupement nitrile ;
- le polychloroprène ;
- le styrène-butadiène.

7. Système selon l'une des revendications 1 à 6, dans lequel la matrice tampon (2) possède un module d'Young supérieur ou égal à 1 GPa.

8. Système selon l'une des revendications 1 à 7, dans lequel la structure utile (1) possède un taux de déformation à la rupture, noté $\tau_{R1}$, et la matrice tampon (2) possède un taux de déformation à la rupture, noté $\tau_{R2}$, vérifiant $\tau_{R2} > \tau_{R1}$.

9. Système selon l'une des revendications 1 à 8, dans lequel la matrice tampon (2) est réalisée dans un matériau choisi parmi :

- un polymère, de préférence un polyimide, le polycarbonate, un polyéthérimide, un polyamide-imide, le polyéthylène, un verre, le polyétheréthercétone, le polypropylène, le polyméthacrylate de méthyle, le polyéthersulfone, le polychlorure de vinyle, le polystyrène, le polytéréphtalate d'éthylène ;
- une céramique, de préférence SiN, SiC, $Al_2O_3$.

10. Système selon l'une des revendications 1 à 9, dans lequel la structure utile (1) est choisie parmi une :

- une structure à base d'un matériau de type semiconducteur ;
- une structure à base d'un matériau de type pérovskite ;
- une structure de type cristal photonique ;
- une structure à base d'un matériau composite ;
- un cristal ;
- un métal ;
- un polymère ;
- une céramique ;
- une chaux ;
- un ciment.

11. Système selon l'une des revendications 1 à 10, dans lequel les moyens de compression comportent une plaque inférieure (5a) et une plaque supérieure (5b), agencées pour enserrer l'empilement.

12. Système selon la revendication 11, en combinaison avec la revendication 5 ou 6, dans lequel la plaque supérieure (5b) présente une surface de contact non-plane avec la couche caoutchoutique (3), la surface de contact non-plane étant géométriquement adaptée de sorte que la couche caoutchoutique (3) convertit la force de compression (F) en des forces de cisaillement (f) longitudinales, parallèles au plan moyen de l'interface, s'appliquant de manière anisotrope à la matrice tampon (2).

13. Système selon l'une des revendications 1 à 12, dans lequel l'empilement comprend une couche anti-glissement (4), intercalée entre la structure utile (1) et la matrice tampon (2), la couche anti-glissement (4) possédant un coefficient de friction adapté pour maintenir en position la structure utile (1) au sein de l'empilement.

14. Système selon l'une des revendications 1 à 12, dans lequel l'empilement comprend un film de collage (4'), intercalé entre la structure utile (1) et la matrice tampon (2).

15. Ensemble de caractérisation d'une structure utile (1) à déformer, comportant :

- un système selon l'une des revendications 1 à 14 ;
- un instrument (7) de caractérisation, agencé pour mesurer la déformation de la structure utile (1), l'instrument (7) de caractérisation étant de préférence choisi parmi :

un spectroscope, de préférence un diffractomètre à rayons X, un spectromètre Raman, un spectroscope de photoluminescence, un spectroscope de réflectance ;
un instrument de mesure de la résistivité électrique, de préférence par la méthode des quatre pointes ou par la méthode de Van der Pauw.

16. Ensemble de caractérisation selon la revendication 15, dans lequel :

- les moyens de compression comportent une plaque inférieure (5a) et une plaque supérieure (5b), agencées pour enserrer l'empilement ;
- l'empilement comprend :

une première couche caoutchoutique (3), intercalée entre la matrice tampon (2) et la plaque supérieure (5b) ;
une deuxième couche caoutchoutique (3'), intercalée entre la plaque inférieure (5a) et la structure utile (1) ;
l'empilement possédant une interface additionnelle entre la structure utile (1) et la deuxième couche caoutchoutique (3'), l'interface additionnelle présentant un plan moyen ;

- les moyens de cisaillement comportent la première couche caoutchoutique (3), la première couche caoutchoutique (3) étant adaptée pour convertir la force de compression (F) en des forces de cisaillement (f) longitudinales, parallèles au plan moyen de l'interface, s'appliquant à la matrice tampon (2) ;
- la deuxième couche caoutchoutique (3') est adaptée pour convertir la force de compression (F) en des forces de cisaillement (f) longitudinales s'appliquant à la structure utile (1), dans le plan moyen de l'interface additionnelle.

17. Ensemble de fabrication d'une structure utile (1) déformée sur un substrat support (S), l'ensemble de fabrication comportant :

- un système selon l'une des revendications 1 à 14 ;
- le substrat support (S) ;

l'empilement étant formé sur le substrat support (S).

18. Ensemble de fabrication selon la revendication 17, dans lequel l'empilement comprend une couche d'air (8), agencée sous la structure utile (1), et adaptée pour mettre à distance la structure utile (1) du substrat support (S).

19. Ensemble de fabrication selon la revendication 18, dans lequel le substrat support (S) est perméable à l'air ; l'ensemble de fabrication comportant des moyens de circulation, agencés pour faire circuler un flux d'air à partir du substrat support (S) vers la couche d'air (8) de sorte que le flux d'air génère une force de sustentation maintenant en position la structure utile (1) au sein de l'empilement.

20. Ensemble de fabrication selon la revendication 19, dans lequel les moyens de circulation comportent un régulateur, agencé pour réguler le flux d'air circulant au sein de la couche d'air (8).

21. Ensemble de fabrication d'une structure utile déformée sur un substrat support (S), comprenant le système de la revendication 1, l'empilement dudit système comprenant successivement, tout d'abord, le substrat support (S), un film de collage (FC), suivi de la structure utile (1) et la matrice tampon (2).

22. Ensemble de fabrication selon la revendication 21, comportant une couche de détachement, intercalée entre le film de collage (FC) et la structure utile (1), la couche de détachement étant adaptée pour détacher le substrat support (S) lorsque la couche de détachement est soumise à un traitement thermique.

23. Ensemble de fabrication selon la revendication 21 ou 22, dans lequel le film de collage (FC) est réalisé dans un matériau polymère ; l'ensemble de fabrication comportant des moyens d'émission (9), agencés pour émettre un rayonnement électromagnétique (90) à travers le substrat support (S) de manière à irradier le film de collage (FC), le substrat support (S) étant transparent au rayonnement électromagnétique (90).

**Patentansprüche**

1. Ein System zum Verformen einer effektiven Struktur (1), umfassend:

   - einen Stapel, der nacheinander die wirksame Struktur (1) und eine Puffermatrix (2) umfasst, wobei der Stapel eine Grenzfläche zwischen der wirksamen Struktur (1) und der Puffermatrix (2) aufweist, wobei die Grenzfläche eine mittlere Ebene aufweist;
   - Kompressionsmittel, die dazu ausgelegt sind, eine Kompressionskraft (F) auf den Stapel entlang einer Achse (Z'-Z) senkrecht zur mittleren Ebene der Grenzfläche auszuüben;
   - eine Schereinrichtung, die dazu ausgelegt ist, auf die Puffermatrix (2) Längsscherkräfte (f) parallel zur mittleren Ebene der Grenzfläche auszuüben;

   wobei die Puffermatrix (2) dazu ausgelegt ist, die Scherkräfte (f) in der mittleren Ebene der Grenzfläche auf die effektive Struktur (1) zu übertragen, um die effektive Struktur (1) zu verformen.

2. System nach Anspruch 1, wobei die Schervorrichtung ein Element (6) umfasst, um die Puffermatrix (2) in Translationsbewegung in einer Längsrichtung parallel zur mittleren Ebene der Schnittstelle zu halten.

3. Das System nach Anspruch 2, wobei die Schereinrichtung ein Gelenkparallelogramm umfasst, das dazu ausgelegt ist, das Halteelement (6) in Längsrichtung translatorisch zu bewegen.

4. System nach Anspruch 2 oder 3, wobei das Halteelement (6) um eine Drehachse ($\omega$) senkrecht zur mittleren Ebene der Grenzfläche drehbar ist.

5. System nach einem der Ansprüche 1 bis 4, wobei der Stapel eine Gummischicht (3) umfasst, wobei sich die Puffermatrix (2) zwischen der wirksamen Struktur (1) und der Gummischicht (3) befindet und die Schereinrichtung die Gummischicht (3) umfasst, wobei die Gummischicht (3) dazu ausgelegt ist, die auf die Puffermatrix (2) ausgeübte Druckkraft (F) in Längsscherkräfte (f) parallel zur mittleren Ebene der Grenzfläche umzuwandeln.

6. Das System gemäß Anspruch 5, wobei die Gummischicht (3) aus einem Material hergestellt ist, das ausgewählt ist aus:

   - einem Polymer vom Silikontyp, das vorzugsweise Polydimethylsiloxan (PDMS) enthält;
   - Vinylethylenacetat;
   - Polyurethan;
   - Polyacryl;
   - Butadien;
   - eine Verbindung, die eine Butylgruppe enthält;
   - ein Kautschuk vom Typ EPDM;
   - Fluorelastomer, insbesondere Perfluorelastomer;
   - Isopren;
   - eine Verbindung mit einer Nitrilgruppe;
   - Polychloropren;
   - Styrol-Butadien.

7. Das System gemäß einem der Ansprüche 1 bis 6, wobei die Puffermatrix (2) einen Elastizitätsmodul von größer oder gleich 1 GPa aufweist.

8. Das System gemäß einem der Ansprüche 1 bis 7, wobei die wirksame Struktur (1) eine Bruchdeformationsrate $\tau_{R1}$ und die Puffermatrix (2) eine Bruchdeformationsrate $\tau_{R2}$ aufweist, die die Bedingung $\tau_{R2} > \tau_{R1}$ erfüllen.

9. Das System gemäß einem der Ansprüche 1 bis 8, wobei die Puffermatrix (2) aus einem Material hergestellt ist, das ausgewählt ist aus:

   - einem Polymer, vorzugsweise einem Polyimid, Polycarbonat, Polyetherimid, Polyamidimid, Polyethylen, Glas, Polyetheretherketon, Polypropylen, Polymethylmethacrylat, Polyethersulfon, Polyvinylchlorid, Polystyrol, Polyethylenterephthalat;
   - einer Keramik, vorzugsweise SiN, SiC, $Al_2 O_3$.

**10.** Das System gemäß einem der Ansprüche 1 bis 9, wobei die wirksame Struktur (1) ausgewählt ist aus:

- einer Struktur auf Basis eines halbleiterartigen Materials;
- einer Struktur auf Basis eines Materials vom Perowskit-Typ;
- einer Struktur vom Typ eines photonischen Kristalls;
- einer Struktur auf Basis eines Verbundmaterials;
- einem Kristall;
- ein Metall;
- ein Polymer;
- eine Keramik;
- Kreide;
- Zement.

**11.** Das System gemäß einem der Ansprüche 1 bis 10, wobei die Kompressionsvorrichtung eine untere Platte (5a) und eine obere Platte (5b) umfasst, die so ausgelegt sind, dass sie fest um den Stapel passen.

**12.** Das System gemäß Anspruch 11 in Kombination mit Anspruch 5 oder 6, wobei die obere Platte (5b) eine nicht ebene Oberfläche aufweist, die mit der Gummischicht (3) in Kontakt steht, wobei die nicht ebene Kontaktfläche geometrisch so gestaltet ist, dass die Gummischicht (3) die Druckkraft (F) in Längsscherkräfte (f) umwandelt, die parallel zur mittleren Ebene der Grenzfläche verlaufen und anisotrop auf die Puffermatrix (2) wirken.

**13.** System nach einem der Ansprüche 1 bis 12, wobei der Stapel eine Anti-Rutsch-Schicht (4) zwischen der effektiven Struktur (1) und der Puffermatrix (2) umfasst, wobei die Anti-Rutsch-Schicht (4) einen Reibungskoeffizienten aufweist, der so ausgelegt ist, dass er die effektive Struktur (1) in ihrer Position im Stapel hält.

**14.** Das System nach einem der Ansprüche 1 bis 12, wobei der Stapel eine Verbindungsschicht (4') zwischen der wirksamen Struktur (1) und der Puffermatrix (2) umfasst.

**15.** Eine Baugruppe zur Charakterisierung einer zu verformenden effektiven Struktur (1), umfassend:

- ein System gemäß der Erfindung nach einem der Ansprüche 1 bis 14;
- ein Charakterisierungsinstrument (7), das dazu ausgelegt ist, die Verformung der effektiven Struktur (1) zu messen, wobei das Charakterisierungsinstrument (7) vorzugsweise ausgewählt ist aus:

einem Spektroskop, vorzugsweise einem Röntgendiffraktometer, einem Raman-Spektrometer, einem Photolumineszenzspektroskop, einem Reflexionsspektroskop;
einem Instrument zur Messung des elektrischen Widerstands, vorzugsweise nach der Vierpunktmethode oder nach der Van-der-Pauw-Methode.

**16.** Die Charakterisierungsvorrichtung gemäß Anspruch 15, wobei:

- die Kompressionsvorrichtung eine untere Platte (5a) und eine obere Platte (5b) umfasst, die so ausgelegt sind, dass sie fest um den Stapel passen;
- der Stapel umfasst:

eine erste Gummischicht (3) zwischen der Puffermatrix (2) und der oberen Platte (5b); eine zweite Gummischicht (3') zwischen der unteren Platte (5a) und der wirksamen Struktur (1);
der Stapel eine zusätzliche Grenzfläche zwischen der wirksamen Struktur (1) und der zweiten Gummischicht (3') aufweist, wobei die zusätzliche Grenzfläche eine mittlere Ebene aufweist;

- Die Schermittel umfassen die erste Gummischicht (3), wobei die erste Gummischicht (3) so ausgelegt ist, dass sie die Druckkraft (F) in Längsscherkräfte (f) umwandelt, die parallel zur mittleren Ebene der Schnittstelle auf die Puffermatrix (2) wirken.
- die zweite Gummischicht (3') dazu ausgelegt ist, die Druckkraft (F) in Längsscherkräfte (f) umzuwandeln, die auf die wirksame Struktur (1) in der mittleren Ebene der zusätzlichen Grenzfläche ausgeübt werden.

**17.** Eine Vorrichtung zur Herstellung einer verformten effektiven Struktur (1) auf einem Trägersubstrat (S), wobei die Herstellungsvorrichtung umfasst:

- ein System gemäß einem der Ansprüche 1 bis 14;
- das Trägersubstrat (S);

wobei der Stapel auf dem Trägersubstrat (S) ausgebildet ist.

18. Die Fertigungsanordnung nach Anspruch 17, wobei der Stapel eine Luftschicht (8) unterhalb der effektiven Struktur (1) umfasst, die dazu ausgelegt ist, die effektive Struktur (1) vom Trägersubstrat (S) zu beabstanden.

19. Die Fertigungsanordnung nach Anspruch 18, wobei das Trägersubstrat (S) luftdurchlässig ist und die Fertigungsanordnung eine Zirkulationseinrichtung umfasst, die dazu ausgelegt ist, einen Luftstrom vom Trägersubstrat (S) zur Luftschicht (8) zirkulieren zu lassen, so dass der Luftstrom eine Auftriebskraft erzeugt, die die effektive Struktur (1) in ihrer Position im Stapel hält.

20. Die Fertigungsanordnung nach Anspruch 19, wobei die Zirkulationsvorrichtung einen Regler umfasst, der dazu ausgelegt ist, den in der Luftschicht (8) zirkulierenden Luftstrom zu regulieren.

21. Eine Vorrichtung zur Herstellung einer verformten effektiven Struktur (1) auf einem Trägersubstrat (S), wobei die Fertigungsvorrichtung umfasst:

   - einen Stapel, der nacheinander das Trägersubstrat (S), eine Verbindungsfolie (FC), die effektive Struktur (1) und eine Puffermatrix (2) umfasst, wobei der Stapel eine Grenzfläche zwischen der effektiven Struktur (1) und der Puffermatrix (2) aufweist, die eine mittlere Ebene hat;
   - Kompressionsmittel, die dazu ausgelegt sind, eine Druckkraft (F) auf den Stapel entlang einer Achse (Z'-Z) senkrecht zur mittleren Ebene der Grenzfläche auszuüben;
   - eine Schereinrichtung, die dazu ausgelegt ist, auf die Puffermatrix (2) Längsscherkräfte (f) parallel zur mittleren Ebene der Grenzfläche auszuüben;

   wobei die Puffermatrix (2) dazu ausgelegt ist, die Scherkräfte (f) in der mittleren Ebene der Grenzfläche auf die effektive Struktur (1) zu übertragen, um die effektive Struktur (1) zu verformen.

22. Die Fertigungsbaugruppe nach Anspruch 21, die eine Trennschicht zwischen der Verbindungsfolie (FC) und der effektiven Struktur (1) umfasst, wobei die Trennschicht dazu ausgelegt ist, das Trägersubstrat (S) zu lösen, wenn die Trennschicht einer Wärmebehandlung unterzogen wird.

23. Die Fertigungsbaugruppe nach Anspruch 21 oder 22, wobei die Verbindungsfolie (FC) aus einem Polymermaterial besteht, wobei die Fertigungsbaugruppe eine Emissionseinrichtung (9) umfasst, die dazu ausgelegt ist, elektromagnetische Strahlung (90) durch das Trägersubstrat (S) hindurch zu emittieren, um die Verbindungsfolie (FC) zu bestrahlen, wobei das Trägersubstrat (S) für die elektromagnetische Strahlung (90) transparent ist.

**Claims**

1. A system for deforming an effective structure (1), including:

   - a stack comprising successively the effective structure (1) and a buffer matrix (2), the stack having an interface between the effective structure (1) and the buffer matrix (2), the interface having a mean plane;
   - compression means designed to apply a compressive force (F) to the stack along an axis (Z'-Z) normal to the mean plane of interface;
   - shear means designed to apply to the buffer matrix (2) longitudinal shear forces (f) parallel to the mean plane of the interface;

   the buffer matrix (2) being designed to transmit the shear forces (f) to the effective structure (1) in the mean plane of the interface so as to deform the effective structure (1).

2. The system as claimed in claim 1, in which the shear means include a member (6) for holding the buffer matrix (2) mobile in translation in a longitudinal direction parallel to the mean plane of the interface.

3. The system as claimed in claim 2, in which the shear means include an articulated parallelogram designed to move the holding member (6) in translation in the longitudinal direction.

4. The system as claimed in claim 2 or 3, in which the holding member (6) is mobile in rotation about a rotation axis ($\omega$) perpendicular to the mean plane of the interface.

5. The system as claimed in any one of claims 1 to 4, in which the stack includes a rubbery layer (3), the buffer matrix (2) being between the effective structure (1) and the rubbery layer (3), and the shear means include the rubbery layer (3), the rubbery layer (3) being designed to convert the compression force (F) into longitudinal shear forces (f) parallel to the mean plane of the interface applied to the buffer matrix (2).

6. The system as claimed in claim 5, in which the rubbery layer (3) is made of a material chosen from:

   - a silicone-type polymer preferably including polydimethylsiloxane (PDMS);
   - vinyl ethylene acetate;
   - polyurethane;
   - polyacrylic;
   - butadiene;
   - a compound including a butyl group;
   - a rubber of EPDM type;
   - a fluoroelastomer, in particular a perfluoroelastomer;
   - isoprene;
   - a compound including a nitrile group;
   - polychloroprene;
   - styrene-butadiene.

7. The system as claimed in any one of claims 1 to 6, in which the buffer matrix (2) has a Young's modulus greater than or equal to 1 GPa.

8. The system as claimed in any one of claims 1 to 7, in which the effective structure (1) has a deformation rate at rupture denoted $\tau_{R1}$ and the buffer matrix (2) has a deformation rate at rupture denoted $\tau_{R2}$ satisfying the condition $\tau_{R2} > \tau_{R1}$.

9. The system as claimed in any one of claim 1 to 8, in which the buffer matrix (2) is made of a material chosen from:

   - a polymer, preferably a polyimide, polycarbonate, polyetherimide, polyamide-imide, polyethylene, glass, polyetheretherketone, polypropylene, polymethylmethacrylate, polyethersulfone, polyvinyl chloride, polystyrene, polyethylene terephthalate;
   - a ceramic, preferably SiN, SiC, $Al_2O_3$.

10. The system as claimed in any one of claims 1 to 9, in which the effective structure (1) is chosen from:

    - a structure based on a semiconductor type material;
    - a structure based on a perovskite type material;
    - a photonic crystal type structure;
    - a structure based on a composite material;
    - a crystal;
    - a metal;
    - a polymer;
    - a ceramic;
    - chalk;
    - cement.

11. The system as claimed in any one of claims 1 to 10, in which the compression means include a lower plate (5a) and an upper plate (5b) designed to fit tightly around the stack.

12. The system as claimed in claim 11 in combination with claim 5 or 6, in which the upper plate (5b) has a non-plane surface in contact with the rubbery layer (3), the non-plane contact surface being geometrically designed so that the rubbery layer (3) converts the compression force (F) into longitudinal shear forces (f) parallel to the mean plane of the interface applied anisotropically to the buffer matrix (2).

13. The system as claimed in any one of claims 1 to 12, in which the stack includes an anti-sliding layer (4) between the effective structure (1) and the buffer matrix (2), the anti-sliding layer (4) having a coefficient of friction designed to hold the effective structure (1) in position in the stack.

14. The system as claimed in any one of claims 1 to 12, in which the stack includes a bonding film (4') between the effective structure (1) and the buffer matrix (2).

15. An assembly for characterization of an effective structure (1) to be deformed, including:

> - a system in accordance with the invention according to any one of claims 1 to 14;
> - a characterization instrument (7) designed to measure the deformation of the effective structure (1), the characterization instrument (7) preferably being chosen from:
>
>> a spectroscope, preferably an X-ray diffractometer, a Raman spectrometer, a photoluminescence spectroscope, a reflectance spectroscope;
>> an instrument for measuring electrical resistivity, preferably by the four point method or by the Van der Pauw method.

16. The characterization assembly as claimed in claim 15, in which:

> - the compression means include a lower plate (5a) and an upper plate (5b) designed to fit tightly around the stack;
> - the stack includes:
>
>> a first rubbery layer (3) between the buffer matrix (2) and the upper plate (5b);
>> a second rubbery layer (3') between the lower plate (5a) and the effective structure (1);
>> the stack having an additional interface between the effective structure (1) and the second rubbery layer (3'), the additional interface having a mean plane;
>
> - the shear means include the first rubbery layer (3), the first rubbery layer (3) being designed to convert the compression force (F) into longitudinal shear forces (f) parallel to the mean plane of the interface applied to the buffer matrix (2);
> - the second rubbery layer (3') is designed to convert the compression force (F) into longitudinal shear forces (f) applied to the effective structure (1) in the mean plane of the additional interface.

17. An assembly for fabrication of a deformed effective structure (1) on a support substrate (S), the fabrication assembly including:

> - a system as claimed in any one of claims 1 to 14;
> - the support substrate (S);

the stack being formed on the support substrate (S).

18. The fabrication assembly as claimed in claim 17, in which the stack includes a layer (8) of air below the effective structure (1) designed to space the effective structure (1) from the support substrate (S).

19. The fabrication assembly as claimed in claim 18, in which the support substrate (S) is permeable to air, the fabrication assembly including circulation means designed to cause a flow of air to circulate from the support substrate (S) toward the layer (8) of air so that the flow of air generates a sustentation force holding the effective structure (1) in position in the stack.

20. The fabrication assembly as claimed in claim 19, in which the circulation means include a regulator designed to regulate the flow of air circulating in the layer (8) of air.

21. An assembly for fabrication of a deformed effective structure (1) on a support substrate (S), the fabrication assembly including:

> - a stack comprising successively the support substrate (S), a bonding film (FC), the effective structure (1) and a buffer matrix (2), the stack having an interface between the effective structure (1) and the buffer matrix (2), the interface having a mean plane;
- compression means designed to apply a compressive force (F) to the stack along an axis (Z'-Z) normal to the mean plane of interface;
- shear means designed to apply to the buffer matrix (2) longitudinal shear forces (f) parallel to the mean plane of the interface;

the buffer matrix (2) being designed to transmit the shear forces (f) to the effective structure (1) in the mean plane of the interface so as to deform the effective structure (1).

22. The fabrication assembly as claimed in claim 21, including a detachment layer between the bonding film (FC) and the effective structure (1), the detachment layer being designed to detach the support substrate (S) when the detachment layer is subjected to a heat treatment.

23. The fabrication assembly as claimed in claim 21 or 22, in which the bonding film (FC) is made of a polymer material, the fabrication assembly including emission means (9) designed to emit electromagnetic radiation (90) through the support substrate (S) in such a manner as to irradiate the bonding film (FC), the support substrate (S) being transparent to the electromagnetic radiation (90).

Fig. 1a

Fig. 1b

Fig. 2a

Fig. 2b

Fig. 3a

Fig. 3b

Fig. 4a

Fig. 4b

Fig. 5a

Fig. 5b

Fig. 6a

Fig. 6b

Fig. 7a

Fig. 7b

Fig. 8a

Fig. 8b

Fig. 9a

Fig. 9b

Fig. 10

Fig. 11a

F

5b

6

2

3

1

6

S

8

## Fig. 11b

F

5b

2

1

3

f

5a

3'

## Fig. 12

Fig. 13

Fig. 14

Fig. 15a

Fig. 15b

Fig. 16a

Fig. 16b

Fig. 17a

Fig. 17b

5b

3

4,4'

2

1

FC

CD

S

## Fig. 18a

F

5b

3

4,4'

2

1

FC

CD

S

5a

90

9

## Fig. 18b

Fig. 19a

Fig. 19b

Fig. 20

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2789518 A1
- US 9559075 A1

- EP 1520669 A1